# EUROPEAN PATENT SPECIFICATION

(11) **EP 4 564 432 B1**
(45) Date of publication and mention of the grant of the patent: **03.06.2026**
(21) Application number: 24178127.7
(22) Date of filing: 27.05.2024
(51) Int. Cl.: H10D 30/67, H10D 86/00, H10D 89/60

(54) **FULLY DEPLETED SEMICONDUCTOR-ON-INSULATOR SWITCH WITH BUILT-IN ELECTROSTATIC DISCHARGE PROTECTION**
VOLLSTÄNDIG VERARMTER HALBLEITER-AUF-ISOLATOR-SCHALTER MIT EINGEBAUTEM ELEKTROSTATISCHEM ENTLADUNGSSCHUTZ
COMMUTATEUR SEMI-CONDUCTEUR SUR ISOLANT ENTIÈREMENT APPAUVRI AVEC PROTECTION INTÉGRÉE CONTRE LES DÉCHARGES ÉLECTROSTATIQUES

(30) Priority: 01.12.2023 US 202318526344
(43) Date of publication of application: 04.06.2025
(73) Proprietor: GlobalFoundries U.S. Inc., Malta, NY 12020 (US)
(72) Inventor: Loiseau, Alain F., Essex Junction 05452 (US); Zhao, Zhixing, Nanjing 211100 (CN); Deng, Guoqing, Waltham 02451 (US); Knorr, Andreas, Malta 12020 (US); Taylor, Richard F., Santa Clara 94086 (US); Mitra, Souvick, Essex Junction 05452 (US); Wolf, Randy L., Essex Junction 05452 (US)
(74) Representative: Grünecker Patent- und Rechtsanwälte PartG mbB

(56) References cited:
- CN-A- 115 001 469
- US-A1- 2011 068 414
- US-A1- 2015 123 206
- US-A1- 2015 228 714
- US-A1- 2018 114 801
- US-A1- 2021 194 125

## Description

### BACKGROUND

The present disclosure relates switches and, more particularly, to embodiments of a fully depleted semiconductor-on-insulator radio frequency (RF) switch.

Switches configured for RF operation (also referred to herein as RF switches) are often incorporated into devices, such as transceivers. A conventional transceiver front-end can include, for example, an antenna, an input/output pad electrically connected the antenna, and an RF switch configured to selectively connect a receiver branch to the input/output pad and thereby, to the antenna. One or more electrostatic discharge (ESD) protection structures (e.g., a shunt inductor or other ESD protection structure) are often integrated into the receiver branch between the RF switch and downstream components and/or between the RF switch and the input/output pad to provide electrostatic discharge. However, the RF switch is not configured for self-protection against ESD or other power surges.
Prior art documents related to the present invention are, for example: US 2018/114801 and US 2015/228714.

### SUMMARY

Disclosed herein are embodiments of a structure. The structure can include a semiconductor layer with a switch area. The switch area can have a first portion and a second portion adjacent to the first portion. The structure can further include a switch. The switch can include series-connected transistors. Together the series-connected transistors can include, within the first portion of the switch area, source/drain regions and channel regions positioned laterally between the source/drain regions. They can also include gates adjacent to the channel regions, respectively. These gates can traverse the first portion of the switch area only such that the second portion of the switch area extends beyond the gates.

Some embodiments of a structure disclosed herein can include a semiconductor layer with multiple switch areas. Each switch area can have a first portion and a second portion adjacent to the first portion. The structure can further include multiple switches. Each switch can include a switch area (i.e., a corresponding one of the switch areas). Each switch can also include series-connected transistors. Together the series-connected transistors can include, within the first portion of the switch area, source/drain regions and channel regions positioned laterally between the source/drain regions. They can also include gates adjacent to the channel regions, respectively. The gates can traverse the first portion of the switch area only such that the second portion of the switch area extends beyond the gates. Each switch can also include resistive elements in the second portion of the switch area connected in parallel to the series-connected transistors. In these embodiments, the switches can be connected in series. For example, adjacent source/drain regions of the series-connected transistors in different switch areas are electrically connected.

Other embodiments of a structure disclosed herein can include a semiconductor layer with a switch area. The switch area can include a first end, a second end opposite the first end, a first portion extending from the first end to the second end, and a second portion adjacent to the first portion and also extending from the first end to the second end. The structure can further include multiple switches. Each switch can include series-connected transistors. Together the series-connected transistors can include, within the first portion of the switch area, source/drain regions and channel regions positioned laterally between the source/drain regions. Together the series-connected transistors can further include gates adjacent to the channel regions, respectively. The gates can traverse the first portion of the switch area only such that the second portion of the switch area extends beyond the gates. The switch can further include resistive elements in the second portion of the switch area connected in parallel to the series-connected transistors. In these embodiments, the multiple switches can include first and second switches connected in parallel. The source/drain regions of the first switch and the source/drain regions of the second switch can include a shared drain region in the first portion of the switch area.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims. The invention is defined by the appended claims.

### BRIEF DESCRIPTION OF THE DRAWINGS

The present disclosure will be better understood from the following detailed description with reference to the drawings, which are not necessarily drawn to scale and in which:
FIG. 1 is a schematic diagram illustrating embodiments of a semiconductor structure including an RF switch;
FIG. 2A is a layout diagram further illustrating the embodiments of the semiconductor structure of FIG. 1;

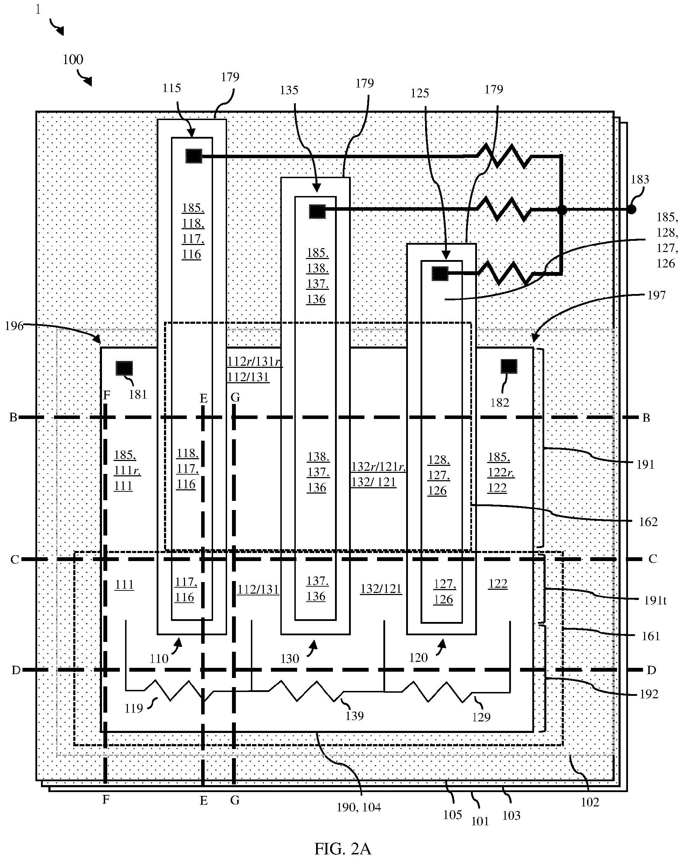

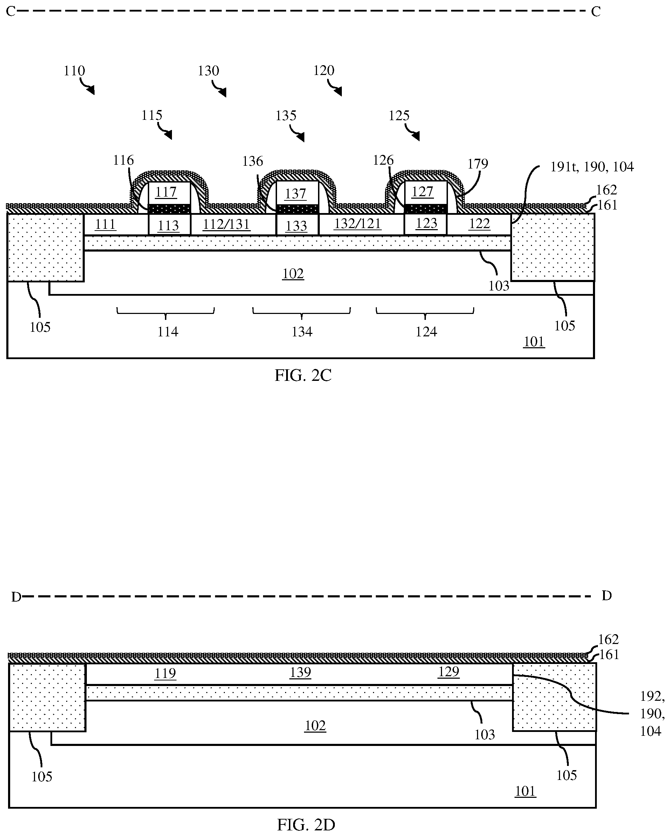

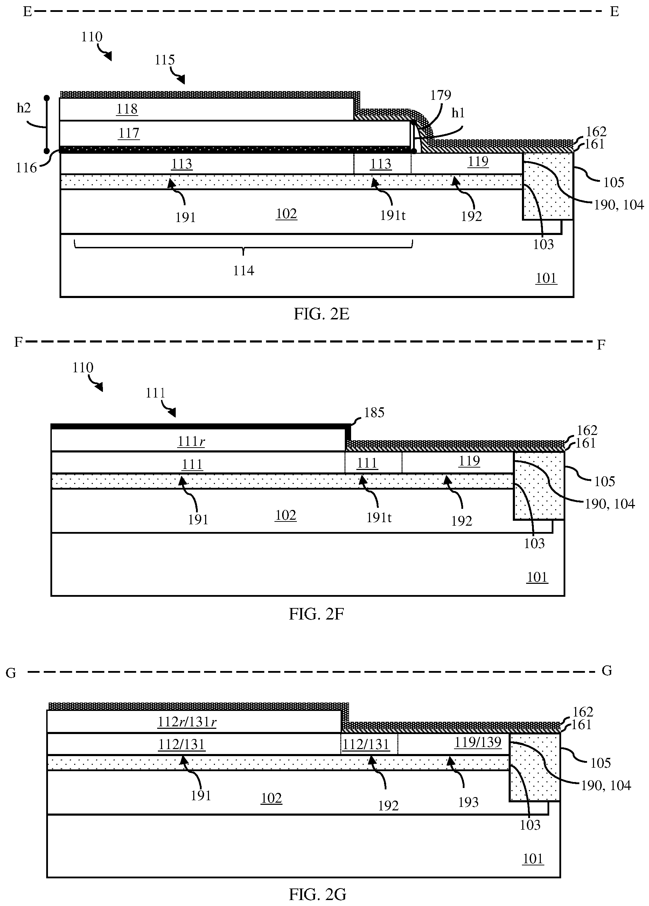

FIGs. 2B-1 to 2B-3 are alternative cross-section diagrams of the semiconductor structure of FIG. 2A illustrating different configurations for the second dielectric layer thereof;
FIGs. 2C-2G are additional cross-section diagrams, respectively, of the semiconductor structure of FIG. 2A;

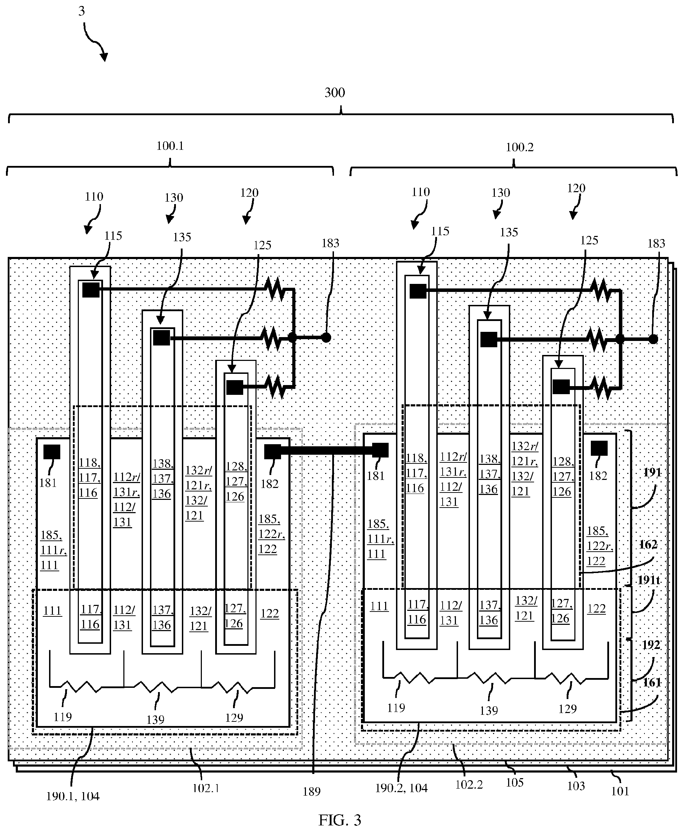

FIG. 3 is a layout diagram illustrating embodiments of a semiconductor structure including multiple RF switches connected in series;

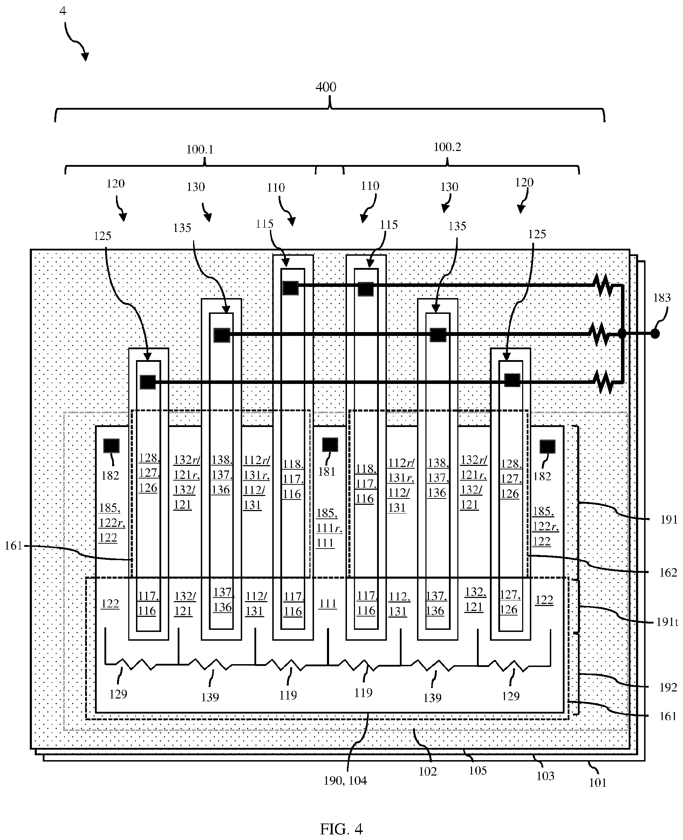

FIG. 4 is a layout diagram illustrating embodiments of a semiconductor structure including two RF switches connected in parallel;

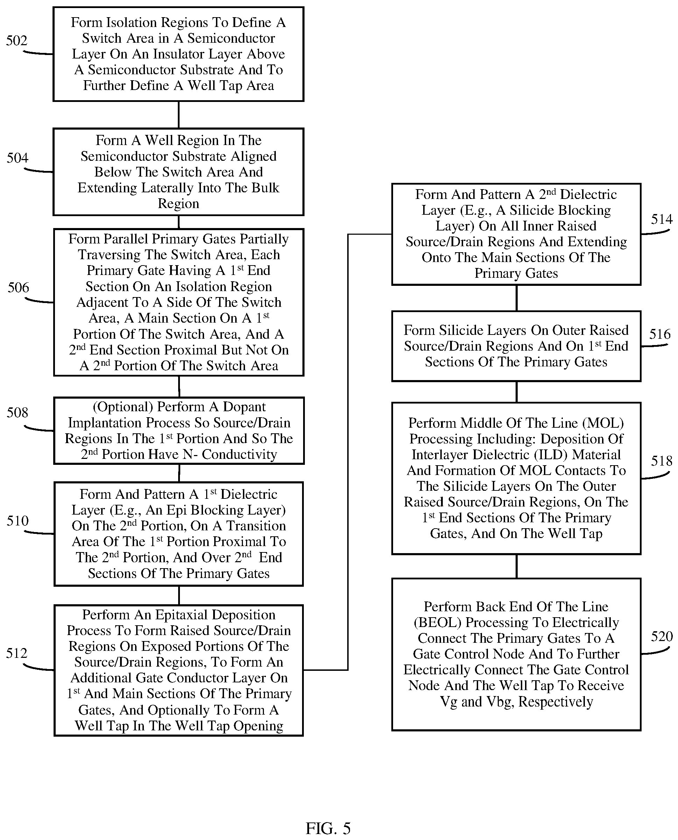

FIG. 5 is a flow diagram illustrating disclosed method embodiments; and

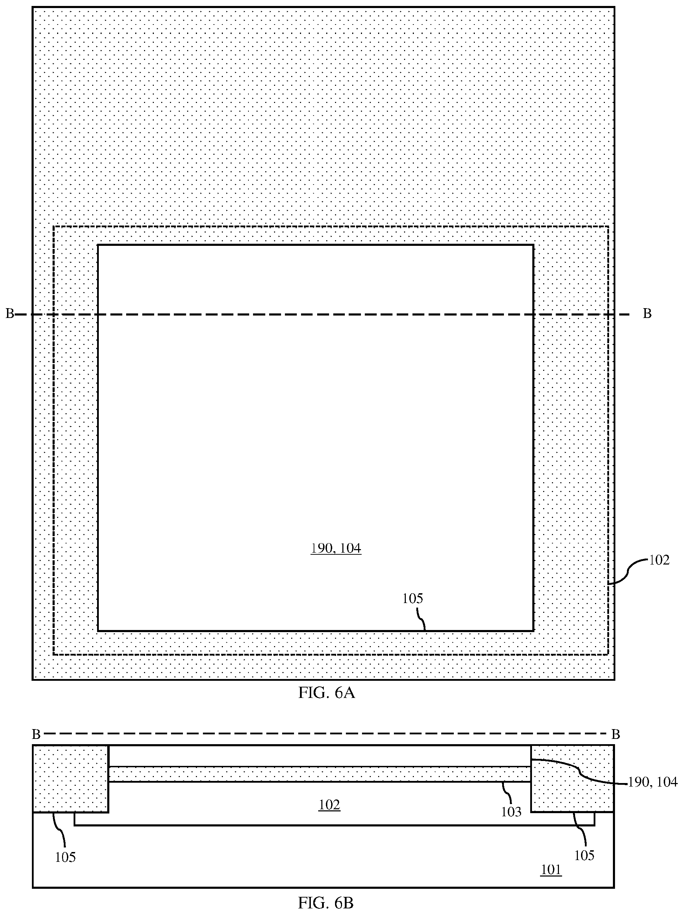

FIGs. 6A-6B, 7A-7D, 8A-8D, 9A-9D, and 10A-10D are diagrams illustrating various steps in the flow diagram of FIG. 5.

### DETAILED DESCRIPTION

As mentioned above, RF switches are typically not configured for self-protection against ESD or other power surges.

In view of the foregoing, disclosed herein are embodiments of a semiconductor structure (e.g., a fully-depleted semiconductor-on-insulator structure, such as a fully depleted silicon-on-insulator (FDSOI) structure) that includes an RF switch with built-in protection from ESD or other power surges. Specifically, the semiconductor structure can include a semiconductor substrate, an insulator layer on the semiconductor substrate, and a semiconductor layer on the insulator layer. The semiconductor layer can have a switch area defined therein (e.g., by trench isolation regions). The switch area can have side-by-side first and second portions, each extending from opposing ends. The semiconductor structure can further include an RF switch. The RF switch can include series-connected transistors (hereinafter referred to as transistors) and resistive elements connected in parallel with the transistors. More specifically, the transistors can include, within the first portion of the switch area, source/drain regions and channel regions positioned laterally between the source/drain regions. The source/drain regions can have raised source/drain regions thereon. The transistors can further include parallel gates, which are adjacent to the channel regions, respectively, which traverse the first portion of the switch area without extending further onto the second portion, and which are connected via resistors to the same gate control node. Outer source/drain regions (e.g., at the opposing ends of the switch area) can be silicided and contacted, whereas inner source/drain regions can be unsilicided and uncontacted. The second portion of the switch area (which extends beyond the ends of the gates) can be in contact with the source/drain regions in the first area, can be unsilicided, and can be either undoped or low doped. Thus, in the disclosed embodiments, the resistive elements, which are connected in parallel with the series-connected transistors, are contained within the second portion of the switch area of the semiconductor layer as opposed to being middle of the line (MOL) or back end of the line (BEOL) resistors connected to the source/drain regions of the transistors via MOL contacts. As a result, the likelihood that ESD or any other power surge will result in the formation of a low resistance "filament" path between the input and output of the RF switch at the outer source/drain regions is minimized. Thus, potential damage to the RF switch is also reduced (i.e., the RF switch includes built-in ESD/power surge protection). As discussed in greater detail below, additional features can also optionally be incorporated into the transistors of the RF switch to further boost such built-in ESD/power surge protection, as discussed below. Furthermore, additional embodiments disclosed herein can include circuits with multiple RF switches (similar to the RF switch described above connected in series or connected in parallel).

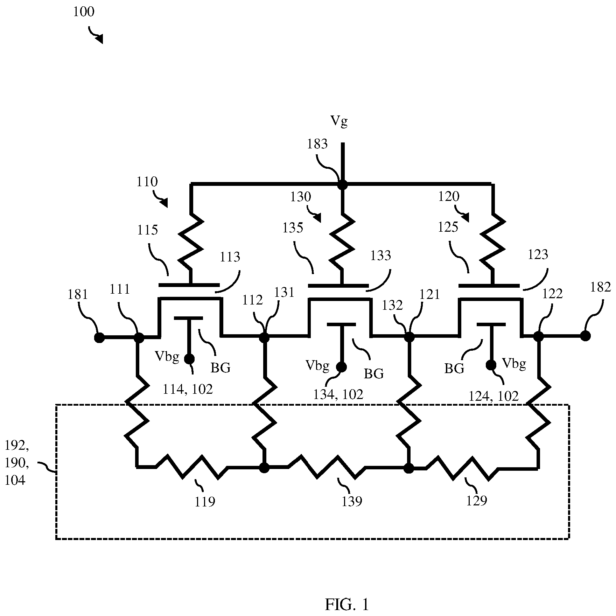

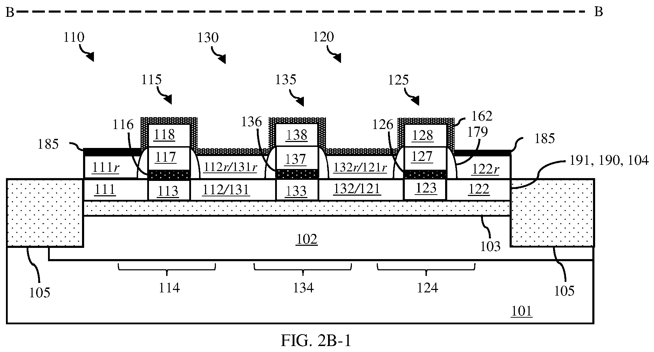

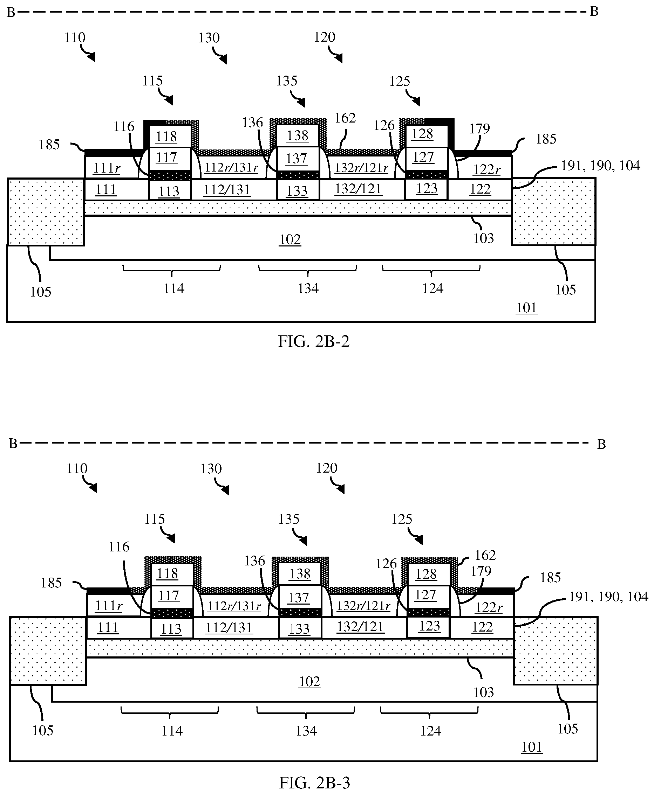

FIG. 1 is a schematic diagram illustrating disclosed embodiments of a semiconductor structure 1 including an RF switch 100 with built-in protection from ESD or other power surges. FIG. 2A is a layout diagram of one example of semiconductor structure 1 of FIG. 1. FIGs. 2B-2G are different cross-section diagrams, respectively, of semiconductor structure 1 of FIG. 2A.

Referring to FIG. 1, generally, RF switch 100 can include multiple field effect transistors (FETs) 110, 120, 130 connected in series (i.e., multiple series-connected FETs) between an input terminal 181 for receiving an RF signal and an output terminal 182 for outputting the RF signal. FETs 110, 120, 130 can be, for example, N-channel FETs (NFETs). For purposes of illustration, three series-connected FETs are shown in the figures. However, it should be understood that the figures are not intended to be limiting. RF switch performance can be improved by increasing the number of stacked FETs. Thus, RF switch 100 can include at least a first FET 110 at one end of the stack connected to input terminal 181 and a second FET 120 at the opposite end of the stack connected to output terminal 182. Optionally, RF switch 100 can include one or more additional FETs (e.g., additional FET 130) connected in series between first FET 110 and second FET 120.

FETs 110, 120, 130 can each include a channel region 113, 123, 133 positioned laterally between source/drain regions 111-112, 121-122, 131-132. FETs 110, 120, 130 can each further include a primary gate 115, 125, 135 (also referred to herein as a front gate) adjacent to the channel region 113, 123, 133. Source/drain regions between the primary gates of adjacent FETs (also referred to herein as inner source/drain regions) can be shared (e.g., see inner source/drain regions 112/131 between primary gates 115 and 135 and inner source/drain regions 132/121 and 121 between primary gates 135 and 125). That is, they can be in the same doped region. Outer source/drain regions (e.g., see source/drain region 111 of FET 110 and source/drain region 122 of FET 120) can be input and output terminals 181-182, respectively, of RF switch 100, can be silicided (i.e., can have silicide layers 185 thereon), and can be contacted (i.e., can have contacts landing thereon). Primary gates 115, 135, 125 can be connected via resistors to the same primary gate control node 183, which receives a primary gate voltage (Vg) for controlling the on/off state of RF switch 100.

As discussed in greater detail below, semiconductor structure 1 can be implemented in a fully depleted semiconductor on insulator technology processing platform (e.g., a fully depleted silicon on insulator (FDSOI) technology processing platform) such that FETs 110, 120, 130 each also have a secondary gate 114, 124, 134 (also referred to herein as a back gate). Secondary gates 114, 124, 134 can be electrically connected to a common secondary gate node, which receives a secondary gate voltage (Vbg), for example, for adjusting the threshold voltages (VTs) of FETs 110, 120, 130.

RF switch 100 can further include resistive elements 119, 129, 139 (also referred to herein as resistors) that are connected in parallel with series-connected FETs 110, 120, 130. However, instead of being conventional back end of the line (BEOL) resistors electrically connected to the source/drain regions of the series-connected FETs of the RF switch via contacts, these resistive elements 119, 129, 139 can be included within a portion 192 of a switch area 190 of a front end of the line (FEOL) semiconductor layer 104. As discussed in greater detail below, a different portion 191 of this same switch area 190 can include the active device regions for FETs 110, 120, 130. By including resistive elements 119, 129, 139 within the FEOL semiconductor layer 104, inner source/drain regions 112/131, 132/121 do not need to be contacted for connection to BEOL resistors and, thus, do not require silicide layers thereon. Instead, inner source/drain regions 112/131, 132/121 can be unsilicided (e.g., can be protected by a silicide blocking layer), thereby minimizing the risk that ESD or any other power surge will result in the formation of a low resistance "filament" path between input and output terminals 181-182.

More particularly, referring to FIGs. 2A-2G in combination with FIG. 1, semiconductor structure 1 can include a semiconductor substrate 101. Semiconductor substrate 101 can be, for example, a monocrystalline silicon substrate or a substrate of any other suitable monocrystalline semiconductor material (e.g., silicon germanium, etc.). In some embodiments, semiconductor substrate 101 can be doped so as to have P-type conductivity at a relatively low conductivity level (e.g., so as to be a P- semiconductor substrate).

Semiconductor structure 1 can further include a semiconductor-on-insulator region (e.g., a silicon-on-insulator (SOI) region). Semiconductor-on-insulator region can include an insulator layer 103 on semiconductor substrate 101. Insulator layer 103 can be, for example, a thin oxide layer (also referred to herein as a buried oxide (BOX) layer), such as a silicon dioxide layer. Alternatively, insulator layer 103 can be a relatively thin layer of any other suitable insulator material. The semiconductor-on-insulator region can further include a thin semiconductor layer 104 on insulator layer 103. Semiconductor layer 104 can be, for example, a monocrystalline silicon layer or a layer of any other suitable monocrystalline semiconductor material (e.g., monocrystalline silicon germanium, etc.).

Semiconductor structure 1 can further include isolation regions 105. Isolation regions 105 can be, for example, shallow trench isolation (STI) regions. Specifically, isolation regions 105 can include trenches, which extend from the top surface of semiconductor layer 104 to and optionally into or through insulator layer 103 (e.g., into semiconductor substrate 101). The trenches can be filled with one or more layers of isolation material (e.g., silicon dioxide, silicon nitride, silicon oxynitride, etc.). Such isolation regions 105 can laterally surround and thereby define the boundaries of a switch area 190 of the semiconductor layer 104. Switch area 190 can be essentially rectangular in shape (e.g., when viewed is a horizontal cross-section). Switch area 190 can have opposing ends 196 and 197 and can further have continuous side-by-side first and second portions 191 and 192 for FET active device regions and for resistive elements 119, 129, 139, respectively.

Semiconductor structure 1 can further include an RF switch 100. RF switch 100 can include multiple series-connected FETs 110, 120, 130 (e.g., NFETs). Each FET 110, 120, 130 can include an active device region in a corresponding portion of first portion 191 of switch area 190 and each active device region can include a channel region 113, 123, 133 positioned laterally between source/drain regions 111-112, 131-132, 121-122. Source/drain regions 111-112, 121-122, 131-132 can have N-type conductivity (e.g., can be N-type source/drain regions) and channel regions 113, 123, 133 can be either intrinsic (i.e., undoped) or can have P-type conductivity at a relatively low conductivity level (e.g., P- channel regions). Inner source/drain regions 112/131, 132/121 can be shared (i.e., can be the same N-doped diffusion region).

FETs 110, 120, 130 can each further include a primary gate 115, 125, 135 adjacent to (e.g., above, and immediately adjacent to) its channel region 113, 123, 133. Primary gates 115, 125, 135 can be parallel to each other and can traverse first portion 191 of switch area 190 without further extending onto second portion 192. Specifically, each primary gate 115, 125, 135 can have a first end section on an isolation region 105 adjacent to one side of switch area 190, can have a main section that extends laterally across first portion 191 toward second portion 192, and can have a second end section proximal to second portion 192 on a transitional area 191t of first portion 191 of switch area 190. Thus, second portion 192 of switch area 190 extends beyond the second end sections of primary gates 115, 125, 135.

Each primary gate 115, 125, 135 can include a gate dielectric layer 116, 126, 136 (including one or more layers of gate dielectric material) immediately adjacent to channel region 113, 123, 133. Each primary gate 115, 125, 135 can further include a gate conductor layer 117, 127, 137 (including one or more layers of gate conductor material) on gate dielectric layer 116, 126, 136. For example, in some embodiments, each primary gate 115, 125, 135 can be a gate-first high-K metal gate (HKMG) gate structure. Such a HKMG structure can include, for example, a gate dielectric layer that includes: an interfacial layer (e.g., an SiO2 layer and/or an SiON layer) immediately adjacent to first portion 191 of switch area 190 of semiconductor layer 104; and a high-K gate dielectric layer (i.e., a layer of dielectric material with a dielectric constant that is greater than 3.9 including, for example, hafnium (Hf)-based dielectrics, such as hafnium oxide, hafnium silicon oxide, hafnium silicon oxynitride, or hafnium aluminum oxide, or other suitable high-k dielectrics, such as aluminum oxide, tantalum oxide, or zirconium oxide) on the interfacial layer. Such a HKMG structure can further include, for example, a gate conductor layer 117, 127, 137 that includes at least: one or more stacked metal layers (e.g., a metal capping layer and an additional metal material layer suitable for dipole formation on the metal capping layer) on the high-K gate dielectric layer and an N-doped polysilicon gate conductor layer (referred to herein as a first polysilicon gate conductor layer) on the metal gate conductor layer(s). As illustrated, gate conductor layer 117, 127, 137 with the uppermost layer being the first polysilicon gate conductor layer can be in all sections of primary gate 115, 125, 135 (i.e., in the first end sections, the second end sections opposite the first end sections, and in the main sections positioned laterally between the first and second end sections).

Optionally, the first end sections (on the isolation region 105) and the main sections of primary gates 115, 125, 135 can further include an additional gate conductor layer 118, 128, 138. Additional gate conductor layer 118, 128, 138 can be a second polysilicon gate conductor layer 118, 128, 138 (e.g., another N-doped polysilicon gate conductor layer) above and immediately adjacent to the first polysilicon gate conductor layer of gate conductor layer 117, 127, 137. In this case, each primary gate 115, 125, 135 has a first height (h1) in the second end section (as measured from the top surface of the semiconductor layer 104) and a second height (h2) greater than h1 in the first end section and the main section.

Gate sidewall spacers 179 can be positioned laterally adjacent to sidewalls of each primary gate (e.g., to electrically isolate the gate structures from adjacent source/drain regions). As illustrated, the top surfaces of gate conductor layer 117, 127, 128 of each primary gate 115, 125, 135 and gate sidewall spacers 179 can be at approximately the same level above semiconductor layer 104. Gate sidewall spacers 179 can be made of one or more layers of dielectric material such as silicon dioxide, silicon oxynitride, silicon nitride, or any other suitable gate sidewall spacer material. Various gate sidewall spacer configurations are well known in the art and, thus, detailed descriptions thereof have been omitted from the specification in order to allow the reader to focus on the salient aspects of the disclosed embodiments. It should be noted that additional gate conductor layer 118, 128, 138 (which as mentioned above is a second gate polysilicon layer) can be in situ doped and epitaxially grown during processing on exposed surfaces of the first polysilicon gate conductor layer. Thus, although not illustrated, some lateral growth may occur such that, within the first end sections and main sections of the primary gates, additional gate conductor layer 118, 128, 138 may extend laterally over gate sidewall spacers 179.

Those skilled in the art will recognize that during FET processing gates with gate sidewall spacers are often formed with a uniform pitch across the semiconductor layer 104 such that non-functioning gates (also referred to herein as dummy gates) land outside device areas (e.g., on isolation regions 105) parallel to functioning gates. Such non-functioning gates may be present in the final semiconductor structure. To avoid clutter in the drawings, non-functioning gate structures are not illustrated in the drawings. However, it should be understood that in the disclosed embodiments non-functioning gates with gate sidewall spacers can be on the isolation regions 105 adjacent the opposing ends of switch area 190 (e.g., positioned laterally adjacent to outer sourced/drain regions of FETs 110, 120 of RF switch 100) and parallel to primary gates 115, 125, 135.

FETs 110, 120, 130 can further include raised source/drain regions 111*r*-112*r*, 131*r*-132*r*, 121*r*-122*r* on source/drain regions 111-112, 131-132, 121-122, respectively. These raised source/drain regions 111*r*-112*r*, 131*r*-132*r*, 121*r*-122*r* can be, for example, in situ doped epitaxial semiconductor layers (e.g., epitaxial silicon layers or epitaxial layers of some other suitable semiconductor material). During processing such epitaxial semiconductor layers can be grown from the source/drain regions below (which are monocrystalline in structure) and, thus, the raised source/drain regions can also be monocrystalline in structure. The epitaxial semiconductor layers can further be in situ doped so that raised source/drain regions 111*r*-112*r*, 131*r-*132*r,* 121*r*-122*r* are N-type conductivity at the same or a higher conductivity level than the source/drain regions below. For example, the raised source/drain regions can be N+ source/drain regions. Optionally, raised source/drain regions 111*r*-112*r*, 131*r-*132*r,* 121*r*-122*r* may extend only partially across the full width of first portion 191 of switch area 190. In this case, raised source/drain regions 111*r*-112*r*, 131*r*-132*r*, 121*r*-122*r* are on opposing sides of the main sections of primary gates 115, 125, 135 and, in transition area 191t, end portions of source/drain regions 111-112, 131-132, 121-122 extend beyond raised source/drain regions 111*r*-112*r*, 131*r*-132*r*, 121*r*-122*r* to second portion 192 of switch area 190 and are on opposing sides of the second end sections of primary gates 115, 125, 135.

A first dielectric layer 161 is above and immediately adjacent to the top surface of second portion 192, the top surfaces of the portions of source/drain regions 111-112, 131-132, 121-122 in transition area 191t, and the top surfaces of the first polysilicon gate conductor layer of gate conductor layer 117, 127, 128 in second end sections of primary gates 115, 125, 135. First dielectric layer 161 can be a blocking material deposited and patterned during processing, as discussed in detail below with regard to the method, to prevent epitaxial semiconductor growth on those specific semiconductor surfaces. The blocking material can be, for example, silicon nitride, silicon oxynitride, or any other dielectric material suitable for blocking epitaxial semiconductor growth.

Outer raised source/drain regions 111*r* and 122*r* of FETs 110 and 120 can be input and output terminals 181 and 182, respectively, of RF switch 100. Outer raised source/drain regions 111*r,* 122*r* can be silicided (i.e., can have silicide layers 185 thereon) and can be contacted (i.e., can have contacts landing thereon). Silicide layers 185 can be, for example, layers of cobalt silicide (CoSi), nickel silicide (NiSi), tungsten silicide (WSi), titanium silicide (TiSi), or any other suitable metal silicide material. Inner raised source/drain regions (e.g., 112*r*/131*r* of FETs 110 and 130 and 132*r*/121*r* of FETs 130 and 120) can be unsilicided and uncontacted.

Specifically, a second dielectric layer 162 can be above and immediately adjacent to each inner raised source/drain region (e.g., see second dielectric layer 162 covering inner raised source/drain regions 112*r*/131*r* and 132*r*/121*r*). Second dielectric layer 162 can be an additional blocking material, which has been deposited and patterned during processing, as discussed in detail below with regard to the method, to prevent metal silicide formation on inner raised source/drain regions 112*r*/131*r* and 132*r*/121*r*. The additional blocking material can be, for example, silicon nitride, silicon oxynitride, or any other dielectric material suitable for blocking silicide formation. The additional blocking material can be the same blocking material or a different blocking material than that used for the first dielectric layer 161.

In any case, second dielectric layer 162 can also be above and immediately adjacent to the main section of any inner primary gate between two inner raised source/drain regions (e.g., see second dielectric layer 162 covering additional gate conductor layer 138 of the main section of primary gate 135 of FET 130). Furthermore, second dielectric layer 162 can extend laterally over the main sections of outer primary gates 115, 125 of FETs 110 and 120 without further extending laterally onto outer raised source/drain regions 111*r,* 122*r* (e.g., as shown in FIG. 2A and FIG. 2B-1). Alternatively, second dielectric layer 162 can extend laterally (and only partially) over the main sections of outer primary gates 115, 125 of FETs 110 and 120 so that the main sections of outer primary gates 115, 125 are partially silicided (e.g., as shown in FIG. 2B-2). Alternatively, second dielectric layer 162 can extend laterally completely over the main sections of outer primary gates 115, 125 of FETs 110 and 120 and can further extend laterally onto an adjacent portion of outer raised source/drain regions 111*r,* 122*r* so that outer raised source/drain regions 111*r,* 122*r* are only partially silicided (e.g., as shown in FIG. 2A and FIG. 2B-2). Optionally, second dielectric layer 162 can also be above and immediately adjacent to first dielectric layer 161 so as to partially or fully cover first dielectric layer 161.

It should be noted that first end sections of the primary gates 115, 125, 135, which are distal to the second portion 192 of switch area 190 and above an isolation region 105, can be devoid of first and second dielectric layers 161-162. Thus, as illustrated, these first end sections can include the additional gate conductor layer 118, 128, 138 and silicide layers 185 thereon. Furthermore, they can be electrically connected by resistors (e.g., via middle of the line (MOL) contacts and BEOL vias and/or wires that form resistors) to the same primary gate control node 183, which receives a primary gate voltage (Vg) for controlling the on/off state of RF switch 100.

Second portion 192 of switch area 190 can be, for example, doped so as to have N-type conductivity. It should be noted that, during processing, second portion 192 can be concurrently doped along with source/drain regions 111-112, 121-122, 131-132 so as to initially have the same N-type conductivity and conductivity level as source/drain regions 111-112, 121-122, 131-132. However, due to diffusion of N-type dopants from N+ raised source/drain regions 111*r*-112*r*, 131*r*-132*r*, 121*r*-122*r* into the source/drain regions 111-112, 121-122, 131-132 below, in the final structure, second portion 192 may be less conductive that source/drain regions 111-112, 121-122, 131-132. Due to the fact that second portion 192 is in contact with the source/drain regions, is relatively thin, has relatively low N-type conductivity, and is unsilicided, the segments of second portion 192 that extend past the ends of each primary gate 115, 125, 135 (e.g., see the segment that extends past primary gate 115 between source/drain regions 111 and 112/131, the segment that extends past primary gate 135 between source/drain regions 112/131 and 132/121, and the segment that extends past primary gate 125 between source/drain regions 132/121 and 122) effectively form resistive elements 119, 129, 139 connected in parallel to FETS 110, 120, 130.

As mentioned above, semiconductor structure 1 can be implemented in a fully depleted semiconductor on insulator technology processing platform (e.g., a fully depleted silicon on insulator (FDSOI) technology processing platform) such that FETs 110, 120, 130 each also have a secondary gate 114, 124, 134 (also referred to herein as a back gate). More specifically, a well region 102 can be within and at the top surface of semiconductor substrate 101 immediately adjacent insulator layer 103. Well region 102 can be aligned below switch area 190. For purposes of this disclosure, a well region refers to a region of semiconductor material doped (e.g., via a dopant implantation process or any other suitable doping process) so as to have a particular conductivity type. Well region 102 can be doped so as to have N-type conductivity. (i.e., an Nwell). Alternatively, well region 102 can be doped so as to have P-type conductivity (i.e., a Pwell). It should be understood that if well region 102 is a Pwell, then the semiconductor structure 1 can further include a buried Nwell (not shown) that electrically isolates the Pwell from adjacent Pwells (if any) and from the lower portion of the P- semiconductor substrate below.

Those skilled in the art will recognize that one advantage of fully depleted semiconductor-on-insulator (e.g., FDSOI) technology processing platforms is that NFETs and PFETs can be formed on an insulator layer above either an Nwell or a Pwell in order to achieve different types of NFETs or PFETs with different VTs. As discussed above FETs 110, 120, 130 can be NFETs. For super low threshold voltage (SLVT) or low threshold voltage (LVT) NFETs, switch area 190 can be defined above an Nwell, whereas regular threshold voltage (RVT) or high threshold voltage (HVT) NFETs, switch area 190 can be defined above a Pwell. Whether the NFETs are SLVT or LVT NFETs or whether they are RVT or HVT NFETs will depend upon the design (e.g., device size, etc.) and process specifications (e.g., dopant concentrations, etc.).

Another advantage of fully depleted semiconductor-on-insulator (e.g., FDSOI) technology processing platforms is that back gate biasing (referred to as back-biasing) with a back gate voltage (Vbg) can be employed to fine tune FET VTs. More specifically, each FET 110, 120, 130 can include a secondary gate 114, 124, 134 (also referred to as a back gate). Each secondary gate 114, 124, 134 can include corresponding sections of the insulator layer 103 and well region 102 below. Concurrent back gate biasing can be achieved by applying a particular Vbg to well region 102. Forward back-biasing (FBB) refers to applying a particular Vbg to a back gate to reduce the VT of a FET, whereas reverse back-biasing (RBB) refers to applying a particular Vbg to the back gate to increase VT. Generally, for an NFET, FBB is achieved by applying a +Vbg to the back gate and RBB is achieved by applying a -Vbg.

To facilitate biasing of well region 102, it should be understood that the semiconductor structure 1 can further include a bulk region (also referred to as a hybrid region). The bulk region can be devoid of the insulator layer and instead can include one or more contact regions (also referred to as taps) on the semiconductor substrate immediately adjacent to well region 102 and electrically isolated from the switch area 190 (e.g., by isolation regions 105). Each tap can include, for example, an epitaxially grown monocrystalline semiconductor layer (e.g., an epitaxially grown silicon layer or an epitaxially grown layer of any other suitable semiconductor material) on the top surface of semiconductor substrate 101 immediately adjacent to well region 102. The epitaxially grown semiconductor layer can further be in situ doped or subsequently implanted so as to have the same type conductivity as the well region 102 below (e.g., at a higher conductivity level). Optionally, each tap can further include a silicide layer thereon and can be electrically connected to receive Vbg. Bulk regions with taps to facilitate biasing well regions and thereby back gates of FETs in fully depleted semiconductor on insulator (e.g., FDSOI) structures are well known in the art. Thus, such regions have been omitted from the specification and drawings in order to allow the reader to focus on the salient aspects of the disclosed embodiments related to the configuration of RF switch 100 (e.g., related to resistive elements 119, 129, 139 within second portion 192 of switch area 190 and connected in parallel to series-connected FETs 110, 120, 130 having active device regions within first portion 191 of switch area 190, etc.).

Additional semiconductor structure embodiments disclosed herein include circuits 300, 400 with multiple instances of RF switch 100 (e.g., see RF switches 100.1 and 100.2) connected in series (as shown in FIG. 3) and connected in parallel (as shown in FIG. 4).

Referring to FIG. 3, like semiconductor structure 1 of FIGs. 1 and 2A-2G, semiconductor structure 3 of FIG. 3 can include a semiconductor substrate 101, an insulator layer 103 on the semiconductor substrate 101 and a semiconductor layer 104 on the insulator layer 103. In this case, semiconductor structure 3 can, however, include a circuit 300 with multiple instances of the RF switch (e.g., see RF switches 100.1 and 100.2) connected in series. That is, semiconductor layer 104 can have multiple switch areas 190.1, 190.2 defined therein by isolation regions 105. Switch areas 190.1 and 190.2 can be aligned above corresponding well regions 102.1 and 102.2 in semiconductor substrate 101. RF switches 100.1 and 100.2 can be configured essentially the same as RF switch 100 of FIGs. 1 and 2A-2G as described in detail above. That is, each RF switch 100.1 and 100.2 can include series-connected FETs 110, 120, 130 with active device regions in a first portion 191 of a corresponding switch area 190.1 and 190.2 and with resistive elements 119, 129, 139 in a second portion 192 of corresponding switch area 190.1 and 190.2 so as to be electrically connected in parallel to the FETs 110, 120, 130. Furthermore, an interconnect 189 can electrically connect output terminal 182 of one RF switch 100.1 to input terminal 181 of another RF switch 100.2. Interconnect 189 could be, for example, a local interconnect immediately adjacent to and extending laterally across the isolation region 105 between two switch areas 190.1 and 190.2. Alternatively, interconnect 189 could include a combination of MOL contacts and BEOL wires and/or vias.

Referring to FIG. 4, like semiconductor structure 1 of FIGs. 1 and 2A-2G, semiconductor structure 4 of FIG. 4 can include a semiconductor substrate 101, an insulator layer 103 on semiconductor substrate 101 and a semiconductor layer 104 on insulator layer 103. In this case, semiconductor structure 4 can, however, include a circuit 400 with multiple instances of the RF switch (e.g., see RF switches 100.1 and 100.2) on the same switch area 190. That is, semiconductor layer 104 can have a single switch area 190 defined therein by isolation regions 105. Switch area 190 can be aligned above a corresponding well region 102 in semiconductor substrate 101. RF switches 100.1 and 100.2 in switch area 190 can be connected in parallel. Specifically, RF switches 100.1 and 100.2 can be configured essentially the same as RF switch 100 of FIGs. 1 and 2A-2G as described in detail above. That is, RF switches 100.1 and 100.2 can each have series-connected FETs 110, 120, 130 in a first portion 191 of a switch area 190 and resistive elements 119, 129, 139 in a second portion of switch area 190 so as to be electrically connected in parallel to series-connected FETs 110, 120, 130. However, in this case, RF switches 100.1 and 100.2 are on the same switch area 190 with the tops and bottoms of the FET stacks for RF switches 100.1 and 100.2 being arranged in opposite directions. That is, first FETs 110 of RF switches 100.1 and 100.2 are adjacent to each other in first portion 191 of switch area 190 and have a shared inner source/drain region 111 (centered within the first portion 191) with a shared raised source/drain region *111r* thereon for a shared input terminal 181. Second FETs 120 of RF switches 100.1 and 100.2 can be at opposite ends of the switch area 190. Specifically, these second FETs 120 can have discrete (i.e., not shared) outer source/drain regions 122 at the first end and at the second end, respectively, of switch area 190 within first portion 191 and outer raised source/drain regions 122r thereon for discrete (i.e., not shared) output terminals 182.

Referring to the flow diagram of FIG. 5, disclosed herein are embodiments of a method of forming a semiconductor structure with RF switches as described above. For purposes of illustration, the method is described below and illustrated in the figures with respect to the semiconductor structure 1 with the RF switch 100 of FIGs. 1 and 2A-2G. However, it should be understood that similar processing techniques could be used to form the semiconductor structure 3 of FIG. 3 or the semiconductor structure 4 of FIG. 4.

The method can, for example, include forming isolation regions 105 on an initial semiconductor-on-insulator structure (see process 502 and FIGs. 6A-6B). The initial semiconductor-on-insulator structure can include a monocrystalline semiconductor substrate 101 (e.g., a monocrystalline silicon (Si) substrate or a monocrystalline substrate of some other suitable semiconductor material, such as silicon germanium (SiGe), germanium (Ge), etc.). The semiconductor substrate 101 can, for example, be doped so as to have P-type conductivity at a relatively low conductivity level (e.g., so as to be a P- semiconductor substrate). The initial semiconductor-on-insulator structure can further include an insulator layer 103 on semiconductor substrate 101. Insulator layer 103 can be a silicon dioxide (SiO₂) layer (also referred to herein as a buried oxide (BOX) layer) or a layer of some other insulator material suitable for use in a back gate structure. Insulator layer 103 can be relatively thin (e.g., 50 nm or less). The initial semiconductor-on-insulator structure can further include a semiconductor layer 104 on insulator layer 103. Semiconductor layer 104 can be a monocrystalline Si layer or a monocrystalline layer of some other suitable semiconductor material (e.g., SiGe, Ge, etc.). The semiconductor layer 104 can also be relatively thin (e.g., 22 nm or less). Isolation regions 105 can be formed at process 502 using conventional shallow trench isolation (STI) formation techniques in order to define the boundaries of a switch area 190. For example, trenches for the isolation regions 105 can be lithographically patterned and etched so that they extend from the top surface of semiconductor layer 104 through insulator layer 103 and into semiconductor substrate 101. Following trench formation, one or more layers of isolation material (e.g., silicon dioxide (SiO₂) or any other suitable isolation material) can be deposited so as to fill the trenches. A chemical mechanical polishing (CMP) process can subsequently be performed to remove any of the isolation materials from the top surface of semiconductor layer 104.

The method can further include forming a well region 102 in the semiconductor substrate 101 (see process 504 and FIGs. 6A-6B). For example, a masked dopant implantation process can be performed to form a well region 102 in semiconductor substrate 101 adjacent to the bottom surface of insulator layer 103 and aligned below switch area 190. Techniques for using masked dopant implantation processes to form well regions in a semiconductor substrate are well known in the art. Thus, the details have been omitted from the specification in order to allow the reader to focus on the salient aspects of the disclosed embodiments. In any case, the masked dopant implantation process can be performed so that the resulting well region 102 is below the entire switch area 190 and further extends laterally in some direction beyond the switch area 190 to facilitate contacting via a well tap. As mentioned above with regard to the structure embodiments, well region 102 can be an Nwell or a Pwell. In the case of a Pwell in a P-semiconductor substrate, another dopant implantation process can be performed to form a buried Nwell (not shown) within the semiconductor substrate 101 below and wider than the Pwell so that the buried Nwell electrically isolates the Pwell from a lower portion of the P- semiconductor substrate. As mentioned above, well region 102 can be contacted via a well tap (not shown). The use of well taps in fully depleted semiconductor on insulator (e.g., FDSOI) technology processing platforms is well known in the art. Thus, details thereof have been omitted from the specification and drawings in order to allow the reader to focus on the salient aspects of the disclosed embodiments and to avoid clutter in the drawings.

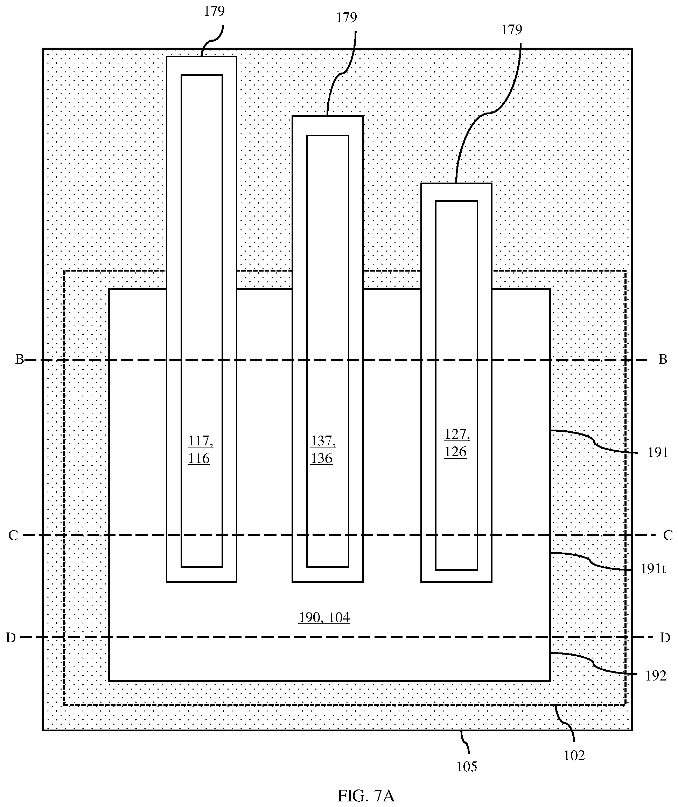

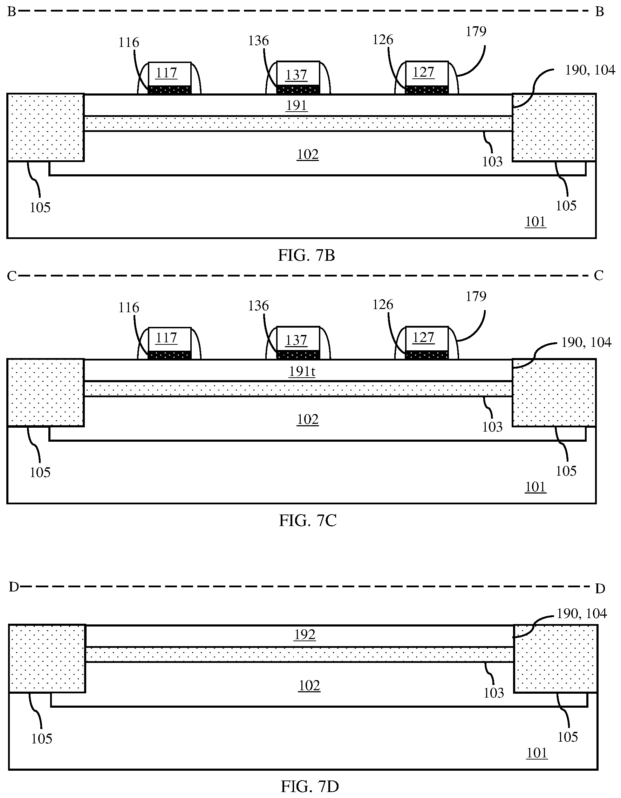

Parallel primary gates 115, 125, 135 can be formed for each FET (e.g., for each series-connected NFET) of the RF switch 100 (see process 506 and FIGs. 7A-7D). Primary gate formation can include depositing one or more layers of gate dielectric materials for a gate dielectric layer, followed by depositing one or more layers of gate conductor materials for a gate conductor layer. In some embodiments, the gate dielectric materials deposited at process 506 can include an interfacial layer (e.g., an SiO2 layer and/or an SiON layer) and a high-K gate dielectric layer (i.e., a layer of dielectric material with a dielectric constant that is greater than 3.9 including, for example, hafnium (Hf)-based dielectrics, such as hafnium oxide, hafnium silicon oxide, hafnium silicon oxynitride, or hafnium aluminum oxide, or other suitable high-k dielectrics, such as aluminum oxide, tantalum oxide, or zirconium oxide) on the interfacial layer. The gate conductor materials deposited at process 506 can include: one or more stacked metal layers (e.g., a metal capping layer and an additional metal material layer suitable for dipole formation on the metal capping layer) on the high-K gate dielectric layer and an N-doped polysilicon gate conductor layer (referred to herein as a first polysilicon gate conductor layer) on the metal gate conductor layer(s). Patterning (e.g., lithographic patterning) and etch processes can subsequently be performed to form initial gate stack(s) for the primary gates 115, 125, 135. While such patterning and etch processes for forming primary gates for series-connected FETs are well known in the art, in the disclosed embodiments the pattern of the resulting primary gates is unique. Specifically, in disclosed embodiments, patterning can be performed so that the resulting primary gates are parallel to each other and traverse a first portion 191 of switch area 190 without further extending onto a second portion 192. More specifically, patterning can be performed so that each primary gate 115, 125, 135 has a first end section on an isolation region 105 adjacent to one side of the switch area 190, a main section that extends laterally across the first portion 191 toward the second portion 192, and a second end section proximal to the second portion 192 on a transitional area 191t of first portion 191 of switch area 190. Thus, the second portion 192 of the switch area 190 extends beyond the second end sections of the primary gates 115, 125, 135.

Additionally, at process 506, gate sidewall spacers 179 can be formed on primary gates 115, 125, 135. For example, one or more layers of dielectric spacer material can be conformally deposited over the partially completed structure. The dielectric spacer material can be, for example, silicon dioxide, silicon oxynitride, or any other suitable dielectric spacer material. Then, a selective anisotropic etch process can be performed to remove the spacer material from horizontal surfaces, leaving it essentially intact as sidewall spacers on vertical surfaces.

Those skilled in the art will recognize that during FET processing gates with gate sidewall spacers are often formed with a uniform pitch across the semiconductor layer 104 such that non-functioning gates (also referred to herein as dummy gates) will also land outside device areas (e.g., on isolation regions 105) parallel to functioning gates. Such non-functioning gates may be present in the final semiconductor structure. To avoid clutter in the drawings non-functioning gate structures are not illustrated in the drawings. However, it should be understood that in the disclosed embodiments non-functioning gates with gate sidewall spacers can be on the isolation regions 105 adjacent the opposing ends of the switch area 190 (e.g., positioned laterally adjacent to outer sourced/drain regions of FETs 110, 120 of the RF switch 100) and parallel to the primary gates 115, 125, 135.

Optionally, a dopant implantation processes can be performed following gate sidewall spacer formation (see process 508). For example, an N-type dopant implantation process can be performed in order to dope exposed semiconductor material in first portion 191 of switch area 190 to form source/drain regions 111-112, 121-122, 131-132 on opposing sides of the main and second end sections of the primary gates 115, 125, 135, respectively, and to further dope exposed semiconductor material in second portion 192. Doping can be performed such that these doped regions have, for example, N-type conductivity at a relatively low conductivity level (e.g., so they are N- regions).

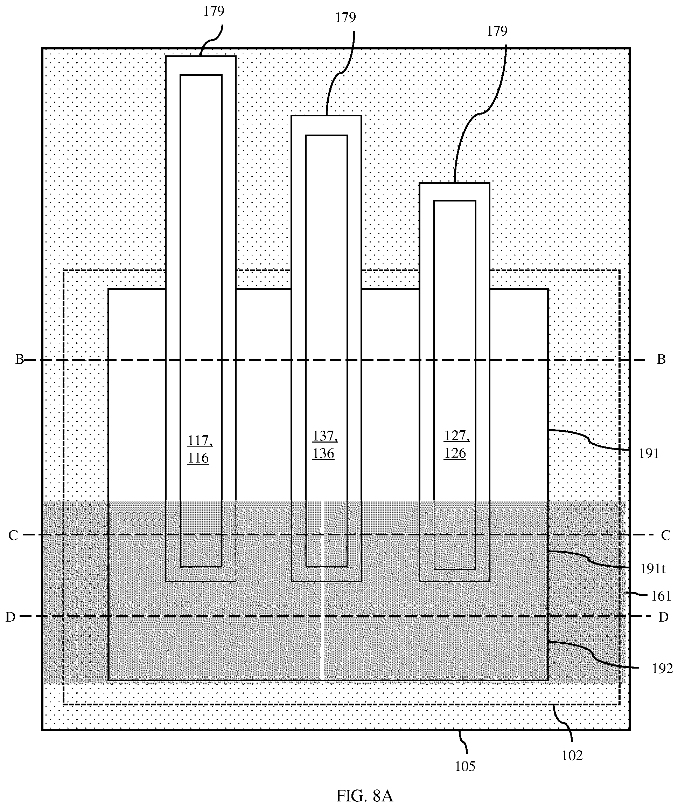

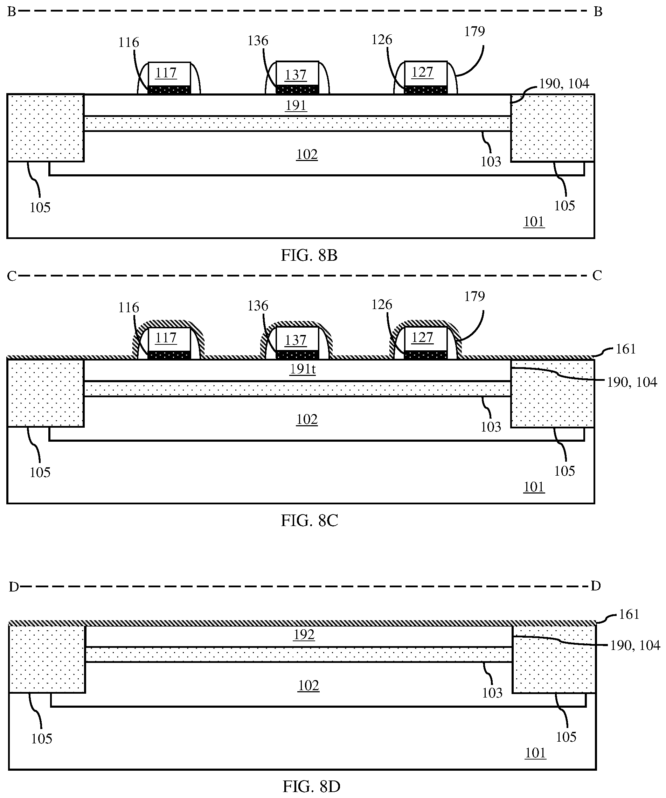

A relatively thin first dielectric layer 161 can be deposited over the partially completed structure and patterned (e.g., lithographically) and etched (see process 510 and FIGs. 8A-8D). Specifically, the first dielectric layer 161 can be patterned and etched so that it remains above and immediately adjacent to the top surface of second portion 192 of switch area 190, the top surfaces of portions of source/drain regions 111-112, 131-132, 121-122 in transition area 191t, and the top surfaces of the first polysilicon gate conductor layer of gate conductor layer 117, 127, 128 in the second end sections of primary gates 115, 125, 135. Thus, following process 508, portions of source/drain regions 111-112, 131-132, 121-122 on opposing sides of the main sections of primary gates 115, 125, 135 and the first polysilicon gate conductor layer of gate conductor layer 117, 127, 137 of the first end and main sections of the primary gates 115, 125, 135 remain exposed. First dielectric layer 161 can be made of a blocking material (referred to herein as an epitaxial semiconductor growth blocking material), such as silicon nitride, silicon oxynitride, or any other dielectric material suitable for blocking epitaxial semiconductor growth.

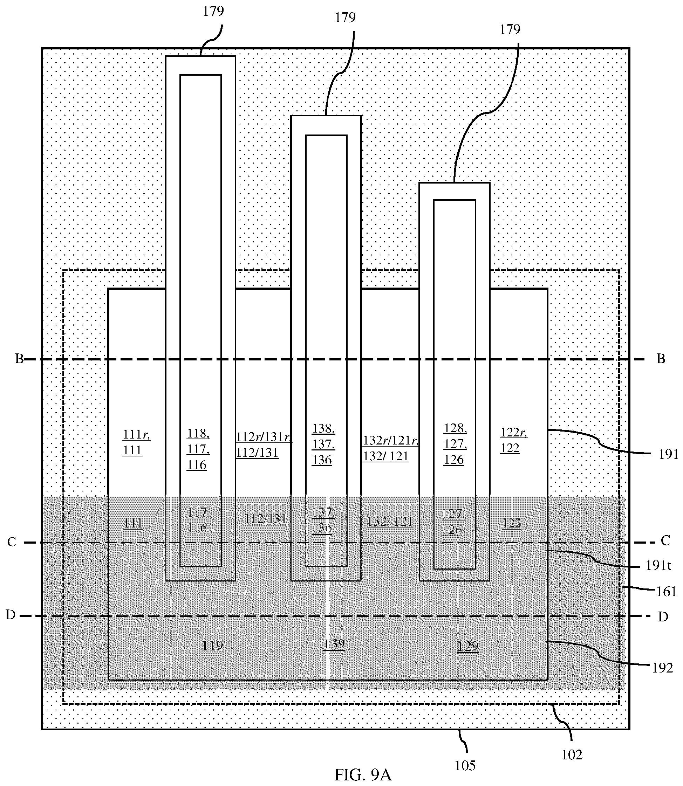

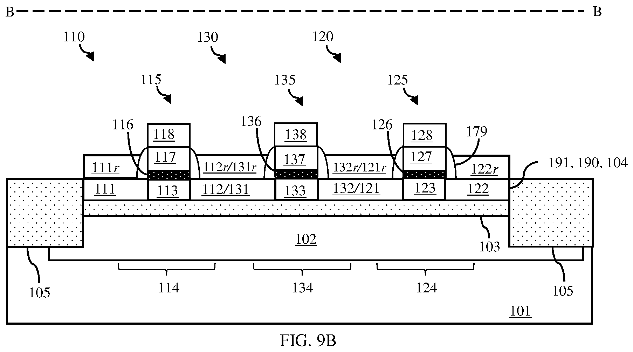

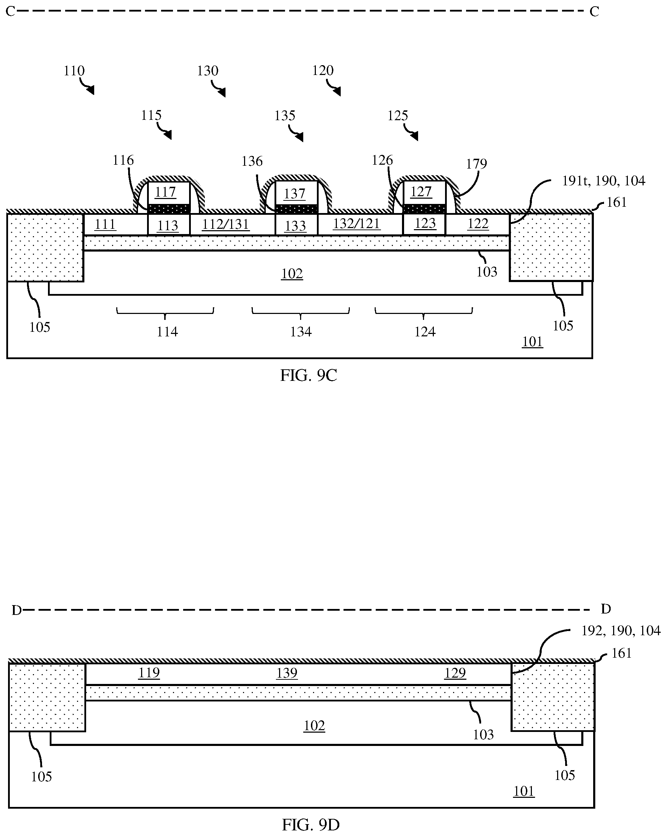

A selective epitaxial deposition process can subsequently be performed to deposit in situ doped epitaxial semiconductor material on exposed semiconductor surfaces (see process 512 and FIGs. 9A-9D). The semiconductor material deposited at process 510 can, for example, be silicon doped so as to have N-type conductivity at a relatively high conductivity level. As a result of this selective epitaxial deposition process, monocrystalline raised source/drain regions 111*r-*112*r,* 131*r-*132*r,* 121*r*-122*r* are formed on portions of source/drain regions 111-112, 131-132, 121-122 on opposing sides of the main sections of the primary gates 115, 125, 135, respectively. Additionally, an additional gate conductor layer 118, 128, 138 (i.e., a second polysilicon gate conductor layer) is formed on the first end and main sections of each primary gate 115, 125, 135 adjacent to the first polysilicon gate conductor layer of gate conductor layer 117, 127, 137.

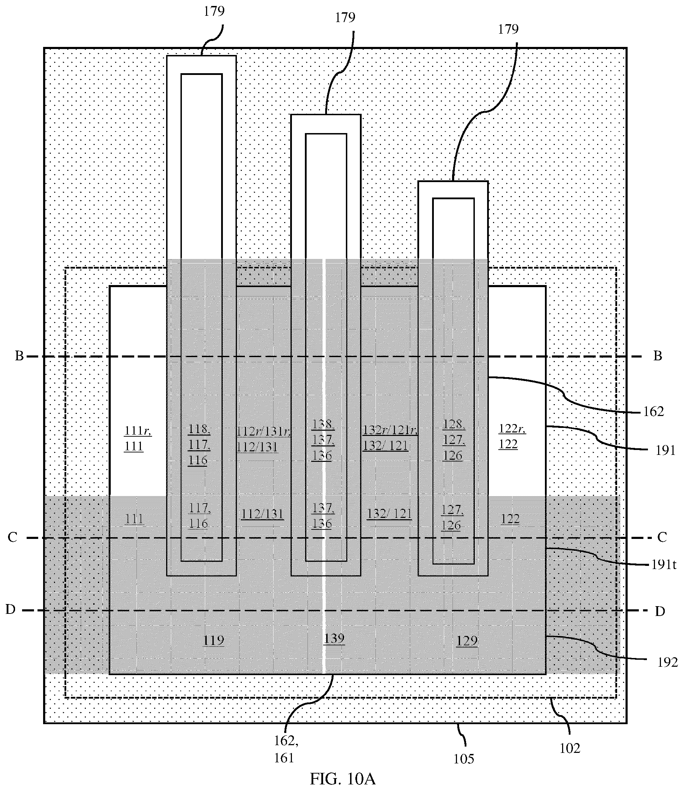

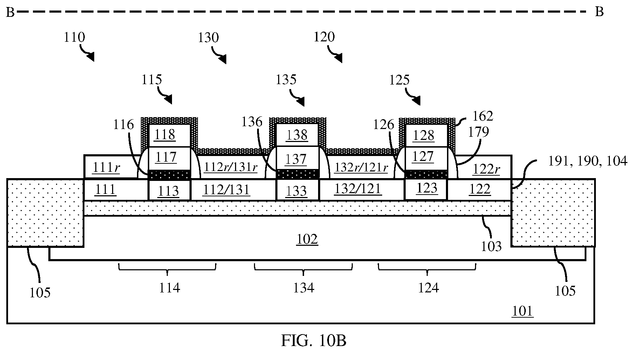

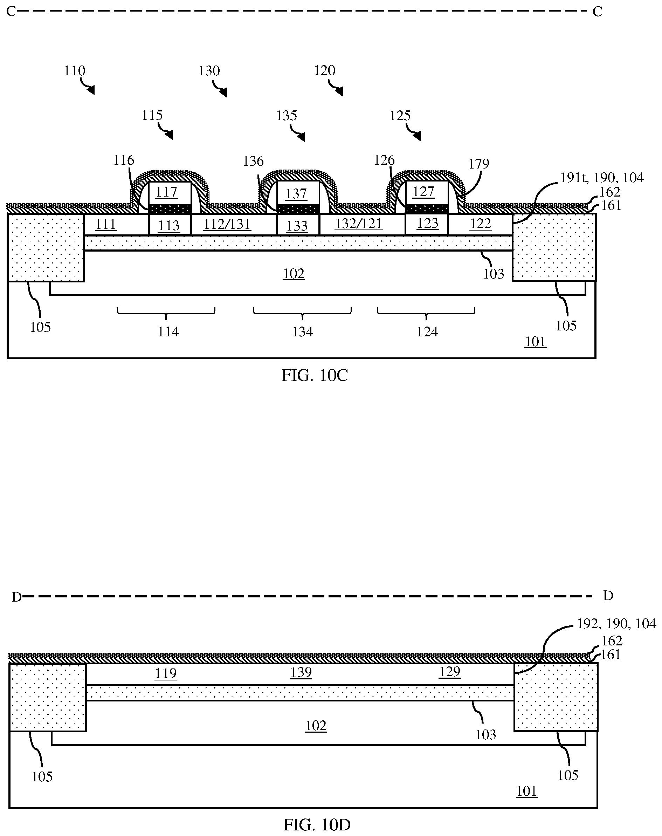

A relatively thin second dielectric layer 162 can be deposited over the partially completed structure and patterned (e.g., lithographically) and etched (see process 514 and FIGs. 10A-10D). Specifically, second dielectric layer 162 can be patterned and etched so that is above and immediately adjacent to each inner raised source/drain region (e.g., see second dielectric layer 162 covering inner raised source/drain regions 112*r*/131*r* and 132*r*/121*r*), leaving each outer raised source/drain region 111*r* and *122*r exposed. As illustrated, second dielectric layer 162 can also be patterned and etched so that it remains above and immediately adjacent to the main section of any primary gate between two inner raised source/drain regions (e.g., see second dielectric layer 162 covering additional gate conductor layer 138 of the main section of primary gate 135 of FET 130). Furthermore, second dielectric layer 162 can be patterned and etched so that it extends laterally over the main sections of primary gates 115, 125 without further extending laterally onto outer raised source/drain regions 111*r,* 122*r* (as illustrated). Alternatively, second dielectric layer 162 can be patterned and etched so that it extends laterally (and only partially) over the main sections of primary gates 115, 125 or so that it extends onto an adjacent portion of outer raised source/drain regions 111*r,* 122*r*. Optionally, second dielectric layer 162 can also be patterned and etched so that it remains above and immediately adjacent to first dielectric layer 161 so as to partially or fully cover first dielectric layer 161. In any case, second dielectric layer 162 can be an additional blocking material (referred to herein as a silicide blocking material), such as silicon nitride, silicon oxynitride, or any other dielectric material suitable for blocking silicide formation. Furthermore, it can be the same blocking material or a different blocking material than that used for the first dielectric layer 161.

Metal silicide layers 185 can then be formed on exposed semiconductor surfaces (e.g., silicon or polysilicon surfaces) including, but not limited to, on the outer raised source/drain regions 111*r* and 122*r*, on the second polysilicon gate conductor layer of the first end sections of the primary gates 115, 125, 135, and on the well tap (not shown) (see process 516 and FIGs. 2A-2G). Depending on how the second dielectric layer 162 is patterned, silicide layers 185 may completely cover the top surfaces of the outer raised source/drain regions (see FIG. 2B-1), may partially cover main sections of primary gates 115 and 125 (see FIG. 2B-2), or may only partially cover the top surfaces of the outer raised source/drain regions (see FIG. 2B-3). Silicide layers 185 could be, for example, layers of cobalt silicide, nickel silicide, tungsten silicide, titanium silicide, or a silicide of any other suitable metal or metal alloy material. Techniques for forming metal silicide layers are well known in the art and, thus, the details thereof have been omitted from this specification to allow the reader to focus on the salient aspects of the disclosed embodiments.

Following silicide formation, middle of the line (MOL) processing can be performed (see process 518). For example, MOL dielectric layer(s) can be formed (e.g., grown, deposited, or otherwise formed) to cover the partially completed structure shown. The MOL dielectric layer(s) can include, for example, an etch stop layer and a blanket interlayer dielectric (ILD) material layer on the etch stop layer. The etch stop layer can be, for example, a relatively thin conformal silicon nitride layer or a relatively thin conformal layer of some other suitable etch stop material. The ILD material layer can be, for example, a blanket layer of silicon dioxide, a doped silicon glass (e.g., phosphosilicate glass (PSG) or borophosphosilicate glass (BPSG)), or a blanket layer of any other suitable ILD material. MOL contacts can be formed using conventional MOL contact formation techniques. Such MOL contacts can include, for example, contacts to the silicide layers 185 on the first end sections of the primary gates 115, 125, 135, on the outer raised source/drain regions 111*r* and 122r, and on the well tap). Back end of the line (BEOL) processing can subsequently be performed (see process 520). BEOL processing can include, for example, using conventional BEOL processing techniques to electrically connect the contacts on the primary gates 115, 125, 135 via resistors to the same primary gate control node 183 and further to electrically the primary gate control node 183 and well tap to bias voltage references generator(s) for receiving Vg and Vgb, respectively.

It should be understood that in the structures and method described above, a semiconductor material refers to a material whose conducting properties can be altered by doping with an impurity. Such semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region. Furthermore, when a semiconductor region or layer is described as being at a higher conductivity level than another semiconductor region or layer, it is more conductive (less resistive) than the other semiconductor region or layer; whereas, when a semiconductor region or layer is described as being at a lower conductivity level than another semiconductor region or layer, it is less conductive (more resistive) than that other semiconductor region or layer.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The descriptions of the various disclosed embodiments have been presented for purposes of illustration but are not intended to be exhaustive or limiting. Many modifications and variations will be apparent to those of ordinary skill in the art without departing from the scope of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a disclosed semiconductor structure includes a semiconductor layer including a switch area with side-by-side first and second portions and an RF switch with built-in ESD/power surge protection. The RF switch includes series-connected transistors, which include, within the first portion of the switch area, source/drain regions and channel regions positioned laterally between the source/drain regions; and parallel gates adjacent to the channel regions, respectively, and traversing the first portion of the switch area without extending further onto the second portion. Outer source/drain regions are silicided and contacted, whereas inner source/drain regions are unsilicided and uncontacted. The second portion of the switch area is in contact with the source/drain regions in the first area, is unsilicided, and is either undoped or low doped. Thus, the second portion makes up resistive elements connected in parallel to the series-connected transistors.

## Claims

1. A structure (1) comprising:
a semiconductor layer (104) including a switch area (190) having a first portion (191) and a second portion (192) adjacent to the first portion (191); and
a switch (100) including series-connected transistors (110, 120, 130), wherein the series-connected transistors (110, 120, 130) include:
within the first portion (191), source/drain regions (111, 112, 121, 122, 131, 132) and channel regions (113, 123, 133) positioned laterally between the source/drain regions (111, 112, 121, 122, 131, 132); and
gates (115, 125, 135) adjacent to the channel regions (113, 123, 133), respectively, wherein the gates (115, 125, 135) traverse the first portion (191) and
wherein the second portion (192) extends beyond the gates (115, 125, 135);
resistive elements (119, 129, 139) in the second portion (192) connected in parallel with the series-connected transistors (110, 120, 130);
wherein the switch area (190) includes a first end and a second end opposite the first end,
wherein the source/drain regions (111, 112, 121, 122, 131, 132) include outer source/drain regions (111, 122) at the first end and at the second end and at least one inner source/drain region (112, 121, 122, 131),
**characterized in that** the switch (100) further includes silicide layers (185) above and immediately adjacent to the outer source/drain regions (111, 122) only of the source/drain regions (111, 112, 121, 122, 131, 132), while the other, at least one, inner source/drain region/regions (112, 121, 131, 132) in the structure (1) is/are unsilicided.

2. The structure of claim 1 wherein the series-connected transistors (110, 120, 130) further include raised source/drain regions (111*r*-112*r*, 131*r-*132*r,* 121*r*-122*r*) on the source/drain regions (111, 112, 121, 122, 131, 132).

3. The structure of claim 2,
wherein the raised source/drain regions (111*r*-112*r*, 131*r*-132*r*, 121*r-*122*r*) include outer raised source/drain regions (111*r,* 122*r*) on the outer source/drain regions (111, 122) and an inner raised source/drain region (112*r*, 131*r*-132*r*, 121*r*) on each inner source/drain region (112, 131, 132, 121), and
wherein the switch (100) further includes silicide layers (185) above and immediately adjacent to the outer raised source/drain regions (111*r,* 122*r*) only of the raised source/drain regions (111*r*-112*r*, 131*r*-132*r*, 121*r*-122*r*).

4. The structure of claim 3,
wherein the gates (115, 125, 135) have main sections positioned laterally between the raised source/drain regions (111*r-*112*r,* 131*r-*132*r,* 121*r-*122*r*) and end sections extending from the main sections, respectively, beyond the raised source/drain regions (111*r*-112*r*, 131*r*-132*r*, 121*r-*122*r*) toward the second portion (192),
wherein the end sections include a first polysilicon gate conductor layer (117, 127, 137) and the main sections include the first polysilicon gate conductor layer (117, 127, 137) and a second polysilicon gate conductor layer (118, 128, 138) on the first polysilicon gate conductor layer (117, 127, 137), and
wherein the end sections have a first height (h1) and the main sections have a second height (h2) that is greater than the first height (h1).

5. The structure of claim 4, further comprising:
a first dielectric layer (161) above and immediately adjacent the second portion (192), extending onto a transition area of the first portion (191) immediately adjacent to the second portion (192), and further extending over the first polysilicon gate conductor layer (117, 127, 137) of the end sections of the gates (115, 125, 135); and
a second dielectric layer (162), wherein the second dielectric layer (162) is above each inner raised source/drain region (112*r,* 131*r*-132*r*, 121*r*) over each inner source/drain region (112, 131, 132, 121) and further above and immediately adjacent to the second polysilicon gate conductor layer (118, 128, 138) of the main sections of the gates (115, 125, 135).

6. The structure of claim 5, wherein the second dielectric layer (162) extends laterally over outer gates (115, 135) of the gates (115, 125, 135) and onto the outer raised source/drain regions (111*r*, 122*r*).

7. The structure of claim 5 or 6, wherein the second dielectric layer (162) extends laterally over outer gates (115, 135) of the gates (115, 125, 135) without extending further onto the outer raised source/drain regions (111*r*, 122*r*).

8. The structure of one of claims 5 to 7, wherein the second dielectric layer (162) extends laterally partially over outer gates (115, 135) of the gates (115, 125, 135).

9. The structure of one of claims 1 to 8,
wherein the series-connected transistors (110, 120, 130) are N-channel field effect transistors,
wherein the source/drain regions (111, 112, 121, 122, 131, 132) have N-type conductivity, and
wherein the second portion (192) has the N-type conductivity at a lower conductivity level than the source/drain regions (111, 112, 121, 122, 131, 132).

10. The structure of one of claims 1 to 9, further comprising:
a semiconductor substrate (101);
a well region (102) in the semiconductor substrate (101);
an insulator layer (103) on the semiconductor substrate (101), wherein the semiconductor layer (104) is on the insulator layer (103); and
trench isolation regions extending through the semiconductor layer (104) to define, above the well region (102), boundaries of the switch area (190).

11. The structure of one of claims 1 to 10, further comprising:
additional switch areas (190) such that the semiconductor layer (104) includes multiple switch areas (190), wherein each switch area (190) has a first portion (191) and a second portion (192) adjacent to the first portion (191); and
additional switches (100.1, 100.2) such that the structure comprises multiple switches (100, 100.1, 100.2),
wherein each switch (100, 100.1, 100.2) includes:
an associated switch area (190) of the multiple switch areas (190); and
series-connected transistors (110, 120, 130) including:
within the first portion (191) of the associated switch area (190), source/drain regions (111, 112, 121, 122, 131, 132) and channel regions (113, 123, 133) positioned laterally between the source/drain regions (111, 112, 121, 122, 131, 132); and
gates (115, 125, 135) adjacent to the channel regions (113, 123, 133), respectively, wherein the gates (115, 125, 135) traverse the first portion (191) of the associated switch area (190) and wherein the second portion (192) of the associated switch area (190) extends beyond the gates (115, 125, 135),
wherein each switch (100, 100.1, 100.2) preferably further comprises resistive elements (119, 129, 139) in the second portion (192) of the switch area (190) connected in parallel to the series-connected transistors (110, 120, 130) and/or the switches (100) are preferably connected in series.

12. The structure of one of claims 1 to 10, wherein the switch area (190) includes a first end, a second end opposite the first end, the first portion (191) extending from the first end to the second end, and the second portion (192) being adjacent to the first portion and extending from the first end to the second end; and
wherein the structure further comprises additional switches (100.1, 100.2) such that the structure comprises multiple switches (100, 100.1, 100.2),
wherein each switch (100, 100.1, 100.2) includes:
series-connected transistors (110, 120, 130) including:
within the first portion (191) of the switch area (190), source/drain regions (111, 112, 121, 122, 131, 132) and channel regions (113, 123, 133) positioned laterally between the source/drain regions (111, 112, 121, 122, 131, 132); and
gates (115, 125, 135) adjacent to the channel regions (113, 123, 133), respectively, wherein the gates (115, 125, 135) traverse the first portion (191) of the switch area (190) and wherein the second portion (192) of the switch area (190) extends beyond the gates (115, 125, 135); and
resistive elements (119, 129, 139) in the second portion (192) of the switch area (190) connected in parallel to the series-connected transistors (110, 120, 130),
wherein the multiple switches (100, 100.1, 100.2) include a first switch and a second switch connected in parallel, and
wherein the source/drain regions (111, 112, 121, 122, 131, 132) of the series-connected transistors (110, 120, 130) of the first switch and the source/drain regions (111, 112, 121, 122, 131, 132) of the series-connected transistors (110, 120, 130) of the second switch include a shared inner source/drain region (112, 131, 132, 121) centered within the first portion (191) of the switch area (190).

13. The structure of claim 11 or 12,
wherein the source/drain regions (111, 112, 121, 122, 131, 132) of the series-connected transistors (110, 120, 130) of the first switch and of the series-connected transistors (110, 120, 130) of the second switch include discrete outer source/drain region (11, 122) at the first end and at the second end, respectively, and
wherein the structure further includes silicide layers (185) above the shared source/drain region (112, 131, 132, 121), the first outer source/drain region (111), and the second outer source/drain region (122), and
wherein all other source/drain regions (112, 131, 132, 121) in the structure are unsilicided.

14. The structure of one of claims 11 to 13,
wherein the gates (115, 125, 135) have main sections positioned laterally between the raised source/drain regions (111*r-*112*r,* 131*r-*132*r,* 121*r-*122*r*) and end sections extending from the main sections, respectively, beyond the raised source/drain regions (111*r*-112*r*, 131*r-*132*r,* 121*r-*122*r*) toward the second portion (192),
wherein the end sections include a first polysilicon gate conductor layer (117, 127, 137) and the main sections include the first polysilicon gate conductor layer (117, 127, 137) and a second polysilicon gate conductor layer (118, 128, 138) on the first polysilicon gate conductor layer (117, 127, 137),
wherein the end sections have a first height (h1) and the main sections have a second height (h2) that is greater than the first height (h1), and
wherein the switches (100, 100.1, 100.2) further include:
a first dielectric layer (161) above and immediately adjacent the second portion (192), extending onto a transition area of the first portion (191) immediately adjacent to the second portion (192), and further extending over the first polysilicon gate conductor layer (117, 127, 137) of the end sections of the gates (115, 125, 135); and
a second dielectric layer (162) above any source/drain region (111, 112, 131, 132, 121, 122) between the shared drain region (112, 131, 132, 121) and the first outer source region (111) or between the shared drain region (112, 131, 132, 121) and the second outer source region (122), and further above and immediately adjacent to the second polysilicon gate conductor layer (118, 128, 138) of the main sections of the gates (115, 125, 135).

## Patentansprüche

1. Struktur (1), umfassend:
eine Halbleiterschicht (104), die einen Schalterbereich (190) mit einem ersten Abschnitt (191) und einem an den ersten Abschnitt (191) angrenzenden zweiten Abschnitt (192) aufweist; und
einen Schalter (100) mit in Reihe geschalteten Transistoren (110, 120, 130), wobei die in Reihe geschalteten Transistoren (110, 120, 130) umfassen:
innerhalb des ersten Abschnitts (191) Source/Drain-Regionen (111, 112, 121, 122, 131, 132) und Kanalregionen (113, 123, 133), die lateral zwischen den Source/Drain-Regionen (111, 112, 121, 122, 131, 132) angeordnet sind; und
Gates (115, 125, 135), die jeweils an die Kanalregionen (113, 123, 133) angrenzen, wobei sich die Gates (115, 125, 135) über den ersten Abschnitt (191) erstrecken und wobei sich der zweite Abschnitt (192) über die Gates (115, 125, 135) hinaus erstreckt;
Widerstandselemente (119, 129, 139) im zweiten Abschnitt (192), die parallel zu den in Reihe geschalteten Transistoren (110, 120, 130) geschaltet sind;
wobei der Schalterbereich (190) ein erstes Ende und ein dem ersten Ende gegenüberliegendes zweites Ende aufweist,
wobei die Source/Drain-Regionen (111, 112, 121, 122, 131, 132) äußere Source/Drain-Regionen (111, 122) am ersten Ende und am zweiten Ende sowie mindestens eine innere Source/Drain-Region (112, 121, 122, 131) umfassen,
**dadurch gekennzeichnet, dass** der Schalter (100) ferner Silizidschichten (185) nur oberhalb und unmittelbar benachbart zu den äußeren Source/Drain-Regionen (111, 122) der Source/Drain-Regionen (111, 112, 121, 122, 131, 132) aufweist, während die andere bzw. die anderen mindestens eine bzw. inneren Source/Drain-Regionen (112, 121, 131, 132) in der Struktur (1) nicht silizidiert ist bzw. sind.

2. Struktur nach Anspruch 1, wobei die in Reihe geschalteten Transistoren (110, 120, 130) ferner erhabene Source/Drain-Regionen (111r-112r, 131r-132r, 121r-122r) auf den Source/Drain-Regionen (111, 112, 121, 122, 131, 132) umfassen.

3. Struktur nach Anspruch 2,
wobei die erhabenen Source/Drain-Regionen (111r-112r, 131r-132r, 121r-122r) äußere erhabene Source/Drain-Regionen (111r, 122r) auf den äußeren Source/Drain-Regionen (111, 122) und eine innere erhabene Source/Drain-Region (112r, 131r-132r, 121r) auf jeder inneren Source/Drain-Region (112, 131, 132, 121) umfassen, und
wobei der Schalter (100) ferner Silizidschichten (185) nur oberhalb und unmittelbar benachbart zu den äußeren erhabenen Source/Drain-Regionen (111r, 122r) der erhabenen Source/Drain-Regionen (111r-112r, 131r-132r, 121r-122r) aufweist.

4. Struktur nach Anspruch 3,
wobei die Gates (115, 125, 135) Hauptabschnitte aufweisen, die lateral zwischen den erhabenen Source/Drain-Regionen (111r-112r, 131r-132r, 121r-122r) angeordnet sind, und Endabschnitte, die sich jeweils von den Hauptabschnitten über die erhabenen Source/Drain-Regionen (111r-112r, 131r-132r, 121r-122r) hinaus in Richtung auf den zweiten Abschnitt (192) erstrecken,
wobei die Endabschnitte eine erste Polysilizium-Gateleiterschicht (117, 127, 137) umfassen und die Hauptabschnitte die erste Polysilizium-Gateleiterschicht (117, 127, 137) und eine zweite Polysilizium-Gateleiterschicht (118, 128, 138) auf der ersten Polysilizium-Gateleiterschicht (117, 127, 137) umfassen, und
wobei die Endabschnitte eine erste Höhe (h1) und die Hauptabschnitte eine zweite Höhe (h2) aufweisen, die größer ist als die erste Höhe (h1).

5. Struktur nach Anspruch 4, ferner umfassend:
eine erste dielektrische Schicht (161) oberhalb des zweiten Abschnitts (192) und unmittelbar benachbart dazu, die sich auf einen Übergangsbereich des ersten Abschnitts (191) unmittelbar benachbart zum zweiten Abschnitt (192) erstreckt und sich ferner über die erste Polysilizium-Gateleiterschicht (117, 127, 137) der Endabschnitte der Gates (115, 125, 135) erstreckt; und
eine zweite dielektrische Schicht (162), wobei die zweite dielektrische Schicht (162) oberhalb jeder inneren erhabenen Source/Drain-Region (112r, 131r-132r, 121r) über jeder inneren Source/Drain-Region (112, 131, 132, 121) und ferner oberhalb und unmittelbar benachbart zur zweiten Polysilizium-Gateleiterschicht (118, 128, 138) der Hauptabschnitte der Gates (115, 125, 135) angeordnet ist.

6. Struktur nach Anspruch 5, wobei sich die zweite dielektrische Schicht (162) lateral über äußere Gates (115, 135) der Gates (115, 125, 135) und auf die äußeren erhabenen Source/Drain-Regionen (111r, 122r) erstreckt.

7. Struktur nach Anspruch 5 oder 6, wobei sich die zweite dielektrische Schicht (162) lateral über äußere Gates (115, 135) der Gates (115, 125, 135) erstreckt, ohne sich weiter auf die äußeren erhabenen Source/Drain-Regionen (111r, 122r) zu erstrecken.

8. Struktur nach einem der Ansprüche 5 bis 7, wobei sich die zweite dielektrische Schicht (162) lateral teilweise über äußere Gates (115, 135) der Gates (115, 125, 135) erstreckt.

9. Struktur nach einem der Ansprüche 1 bis 8,
wobei die in Reihe geschalteten Transistoren (110, 120, 130) N-Kanal-Feldeffekttransistoren sind,
wobei die Source/Drain-Regionen (111, 112, 121, 122, 131, 132) N-Leitfähigkeit aufweisen, und
wobei der zweite Abschnitt (192) die N-Leitfähigkeit auf einem niedrigeren Leitfähigkeitsniveau als die Source/Drain-Regionen (111, 112, 121, 122, 131, 132) aufweist.

10. Struktur nach einem der Ansprüche 1 bis 9, ferner umfassend:
ein Halbleitersubstrat (101);
eine Wannenregion (102) in dem Halbleitersubstrat (101);
eine Isolatorschicht (103) auf dem Halbleitersubstrat (101), wobei die Halbleiterschicht (104) auf der Isolatorschicht (103) angeordnet ist; und
Grabenisolationsregionen, die sich durch die Halbleiterschicht (104) erstrecken, um oberhalb der Wannenregion (102) Grenzen des Schalterbereichs (190) zu definieren.

11. Struktur nach einem der Ansprüche 1 bis 10, ferner umfassend:
zusätzliche Schalterbereiche (190), so dass die Halbleiterschicht (104) mehrere Schalterbereiche (190) aufweist, wobei jeder Schalterbereich (190) einen ersten Abschnitt (191) und einen an den ersten Abschnitt (191) angrenzenden zweiten Abschnitt (192) aufweist; und
zusätzliche Schalter (100.1, 100.2), so dass die Struktur mehrere Schalter (100, 100.1, 100.2) umfasst,
wobei jeder Schalter (100, 100.1, 100.2) umfasst:
einen zugehörigen Schalterbereich (190) der mehreren Schalterbereiche (190); und
in Reihe geschaltete Transistoren (110, 120, 130), die umfassen:
innerhalb des ersten Abschnitts (191) des zugehörigen Schalterbereichs (190) Source/Drain-Regionen (111, 112, 121, 122, 131, 132) und Kanalregionen (113, 123, 133), die lateral zwischen den Source/Drain-Regionen (111, 112, 121, 122, 131, 132) angeordnet sind; und
Gates (115, 125, 135), die jeweils an die Kanalregionen (113, 123, 133) angrenzen, wobei sich die Gates (115, 125, 135) über den ersten Abschnitt (191) des zugehörigen Schalterbereichs (190) erstrecken und wobei sich der zweite Abschnitt (192) des zugehörigen Schalterbereichs (190) über die Gates (115, 125, 135) hinaus erstreckt,
wobei jeder Schalter (100, 100.1, 100.2) vorzugsweise ferner Widerstandselemente (119, 129, 139) im zweiten Abschnitt (192) des Schalterbereichs (190) umfasst, die parallel zu den in Reihe geschalteten Transistoren (110, 120, 130) geschaltet sind, und/oder die Schalter (100) vorzugsweise in Reihe geschaltet sind.

12. Struktur nach einem der Ansprüche 1 bis 10, wobei der Schalterbereich (190) ein erstes Ende, ein dem ersten Ende gegenüberliegendes zweites Ende, den ersten Abschnitt (191), der sich vom ersten Ende zum zweiten Ende erstreckt, und den zweiten Abschnitt (192), der an den ersten Abschnitt angrenzt und sich vom ersten Ende zum zweiten Ende erstreckt, aufweist; und
wobei die Struktur ferner zusätzliche Schalter (100.1, 100.2) umfasst, so dass die Struktur mehrere Schalter (100, 100.1, 100.2) umfasst,
wobei jeder Schalter (100, 100.1, 100.2) umfasst:
in Reihe geschaltete Transistoren (110, 120, 130), die umfassen:
innerhalb des ersten Abschnitts (191) des Schalterbereichs (190) Source/Drain-Regionen (111, 112, 121, 122, 131, 132) und Kanalregionen (113, 123, 133), die lateral zwischen den Source/Drain-Regionen (111, 112, 121, 122, 131, 132) angeordnet sind; und
Gates (115, 125, 135), die jeweils an die Kanalregionen (113, 123, 133) angrenzen, wobei sich die Gates (115, 125, 135) über den ersten Abschnitt (191) des Schalterbereichs (190) erstrecken und wobei sich der zweite Abschnitt (192) des Schalterbereichs (190) über die Gates (115, 125, 135) hinaus erstreckt; und
Widerstandselemente (119, 129, 139) im zweiten Abschnitt (192) des Schalterbereichs (190), die parallel zu den in Reihe geschalteten Transistoren (110, 120, 130) geschaltet sind,
wobei die mehreren Schalter (100, 100.1, 100.2) einen ersten Schalter und einen zweiten Schalter umfassen, die parallel geschaltet sind, und
wobei die Source/Drain-Regionen (111, 112, 121, 122, 131, 132) der in Reihe geschalteten Transistoren (110, 120, 130) des ersten Schalters und die Source/Drain-Regionen (111, 112, 121, 122, 131, 132) der in Reihe geschalteten Transistoren (110, 120, 130) des zweiten Schalters eine gemeinsame innere Source/Drain-Region (112, 131, 132, 121) umfassen, die innerhalb des ersten Abschnitts (191) des Schalterbereichs (190) zentriert ist.

13. Struktur nach Anspruch 11 oder 12,
wobei die Source/Drain-Regionen (111, 112, 121, 122, 131, 132) der in Reihe geschalteten Transistoren (110, 120, 130) des ersten Schalters und der in Reihe geschalteten Transistoren (110, 120, 130) des zweiten Schalters diskrete äußere Source/Drain-Regionen (11, 122) am ersten Ende bzw. am zweiten Ende umfassen, und
wobei die Struktur ferner Silizidschichten (185) oberhalb der gemeinsamen Source/Drain-Region (112, 131, 132, 121), der ersten äußeren Source/Drain-Region (111) und der zweiten äußeren Source/Drain-Region (122) aufweist, und
wobei alle anderen Source/Drain-Regionen (112, 131, 132, 121) in der Struktur nicht silizidiert sind.

14. Struktur nach einem der Ansprüche 11 bis 13,
wobei die Gates (115, 125, 135) Hauptabschnitte aufweisen, die lateral zwischen den erhabenen Source/Drain-Regionen (111r-112r, 131r-132r, 121r-122r) angeordnet sind, und Endabschnitte, die sich jeweils von den Hauptabschnitten über die erhabenen Source/Drain-Regionen (111r-112r, 131r-132r, 121r-122r) hinaus in Richtung auf den zweiten Abschnitt (192) erstrecken,
wobei die Endabschnitte eine erste Polysilizium-Gateleiterschicht (117, 127, 137) umfassen und die Hauptabschnitte die erste Polysilizium-Gateleiterschicht (117, 127, 137) und eine zweite Polysilizium-Gateleiterschicht (118, 128, 138) auf der ersten Polysilizium-Gateleiterschicht (117, 127, 137) umfassen,
wobei die Endabschnitte eine erste Höhe (h1) und die Hauptabschnitte eine zweite Höhe (h2) aufweisen, die größer ist als die erste Höhe (h1), und
wobei die Schalter (100, 100.1, 100.2) ferner umfassen:
eine erste dielektrische Schicht (161) oberhalb des zweiten Abschnitts (192) und unmittelbar benachbart dazu, die sich auf einen Übergangsbereich des ersten Abschnitts (191) unmittelbar benachbart zum zweiten Abschnitt (192) erstreckt und sich ferner über die erste Polysilizium-Gateleiterschicht (117, 127, 137) der Endabschnitte der Gates (115, 125, 135) erstreckt; und
eine zweite dielektrische Schicht (162) oberhalb jeder Source/Drain-Region (111, 112, 131, 132, 121, 122), die zwischen der gemeinsamen Drain-Region (112, 131, 132, 121) und der ersten äußeren Sourceregion (111) oder zwischen der gemeinsamen Drain-Region (112, 131, 132, 121) und der zweiten äußeren Sourceregion (122) liegt, und ferner oberhalb und unmittelbar benachbart zur zweiten Polysilizium-Gateleiterschicht (118, 128, 138) der Hauptabschnitte der Gates (115, 125, 135).

## Revendications

1. Structure (1) comprenant :
une couche semi-conductrice (104) comprenant une zone de commutation (190) ayant une première partie (191) et une seconde partie (192) adjacente à la première partie (191) ; et
un commutateur (100) comportant des transistors connectés en série (110, 120, 130), dans laquelle les transistors connectés en série (110, 120, 130) comportent :
au sein de la première partie (191), des régions de source/drain (111, 112, 121, 122, 131, 132) et des régions de canal (113, 123, 133) positionnées latéralement entre les régions de source/drain (111, 112, 121, 122, 131, 132) ; et
des grilles (115, 125, 135) adjacentes aux régions de canal (113, 123, 133), respectivement, dans laquelle les grilles (115, 125, 135) traversent la première partie (191) et
dans laquelle la seconde partie (192) s'étend au-delà des grilles (115, 125, 135) ;
des éléments résistifs (119, 129, 139) dans la seconde partie (192) connectés en parallèle avec les transistors connectés en série (110, 120, 130) ;
dans laquelle la zone de commutation (190) comporte une première extrémité et une seconde extrémité opposée à la première extrémité,
dans laquelle les régions de source/drain (111, 112, 121, 122, 131, 132) comportent des régions de source/drain externes (111, 122) au niveau de la première extrémité et au niveau de la seconde extrémité et au moins une région de source/drain interne (112, 121, 122, 131),
**caractérisée en ce que** le commutateur (100) comporte en outre des couches de siliciure (185) situées au-dessus et immédiatement adjacentes aux régions de source/drain externes (111, 122) uniquement parmi les régions de source/drain (111, 112, 121, 122, 131, 132), tandis que l'autre ou les autres régions de source/drain internes (112, 121, 131, 132) de la structure (1) ne sont pas recouvertes de siliciure.

2. Structure selon la revendication 1, dans laquelle les transistors connectés en série (110, 120, 130) comportent en outre des régions de source/drain surélevées (111*r*-112*r*, 131*r*-132*r*, 121*r*-122*r*) sur les régions de source/drain (111, 112, 121, 122, 131, 132).

3. Structure selon la revendication 2,
dans laquelle les régions de source/drain surélevées (111*r-*112*r,* 131*r-*132r, 121*r-*122*r*) comportent des régions de source/drain surélevées externes (111*r*, 122*r*) sur les régions de source/drain externes (111, 122) et une région de source/drain surélevée interne (112*r,* 131*r-*132*r,* 121*r*) sur chaque région de source/drain interne (112, 131, 132, 121), et
dans laquelle le commutateur (100) comporte en outre des couches de siliciure (185) situées au-dessus et immédiatement adjacentes aux régions de source/drain surélevées externes (111*r,* 122*r*) uniquement parmi les régions de source/drain surélevées (111*r-*112*r,* 131*r-*132*r,* 121*r-*122*r*)*.*

4. Structure selon la revendication 3,
dans laquelle les grilles (115, 125, 135) ont des sections principales positionnées latéralement entre les régions de source/drain surélevées (111*r*-112*r*, 131*r*-132*r*, 121*r-*122*r*) et des sections d'extrémité s'étendant respectivement depuis les sections principales au-delà des régions de source/drain surélevées (111*r*-112*r*, 131*r*-132*r*, 121*r-*122*r*) vers la seconde partie (192),
dans laquelle les sections d'extrémité comportent une première couche conductrice de grille en polysilicium (117, 127, 137) et les sections principales comportent la première couche conductrice de grille en polysilicium (117, 127, 137) et une seconde couche conductrice de grille en polysilicium (118, 128, 138) sur la première couche conductrice de grille en polysilicium (117, 127, 137), et
dans laquelle les sections d'extrémité ont une première hauteur (h1) et les sections principales ont une seconde hauteur (h2) qui est supérieure à la première hauteur (h1).

5. Structure selon la revendication 4, comprenant en outre :
une première couche diélectrique (161) située au-dessus et immédiatement adjacente à la seconde partie (192), s'étendant sur une zone de transition de la première partie (191) immédiatement adjacente à la seconde partie (192), et s'étendant en outre sur la première couche conductrice de grille en polysilicium (117, 127, 137) des sections d'extrémité des grilles (115, 125, 135) ; et
une seconde couche diélectrique (162), dans laquelle la seconde couche diélectrique (162) se trouve au-dessus de chaque région de source/drain surélevée interne (112*r,* 131*r-*132*r,* 121*r*) au-dessus de chaque région de source/drain interne (112, 131, 132, 121) et, en outre, au-dessus et immédiatement adjacente à la seconde couche conductrice de grille en polysilicium (118, 128, 138) des sections principales des grilles (115, 125, 135).

6. Structure selon la revendication 5, dans laquelle la seconde couche diélectrique (162) s'étend latéralement sur les parties externes (115, 135) des grilles (115, 125, 135) et sur les régions de source/drain surélevées externes (111r, 122r).

7. Structure selon la revendication 5 ou 6, dans laquelle la seconde couche diélectrique (162) s'étend latéralement sur les grilles extérieures (115, 135) parmi les grilles (115, 125, 135) sans s'étendre davantage sur les régions de source/drain surélevées extérieures (111*r*, 122*r*)*.*

8. Structure selon l'une des revendications 5 à 7, dans laquelle la seconde couche diélectrique (162) s'étend latéralement en partie sur les grilles extérieures (115, 135) parmi les grilles (115, 125, 135).

9. Structure selon l'une des revendications 1 à 8,
dans laquelle les transistors connectés en série (110, 120, 130) sont des transistors à effet de champ à canal N,
dans laquelle les régions de source/drain (111, 112, 121, 122, 131, 132) ont une conductivité de type N, et
dans laquelle la seconde partie (192) présente la conductivité de type N à un niveau de conductivité inférieur à celui des régions de source/drain (111, 112, 121, 122, 131, 132).

10. Structure selon l'une des revendications 1 à 9, comprenant en outre :
un substrat semi-conducteur (101) ;
une région de puits (102) dans le substrat semi-conducteur (101) ;
une couche isolante (103) sur le substrat semi-conducteur (101), dans laquelle la couche semi-conductrice (104) se trouve sur la couche isolante (103) ; et
des régions d'isolation en tranchée s'étendant à travers la couche semi-conductrice (104) pour définir, au-dessus de la région de puits (102), des limites de la zone de commutation (190).

11. Structure selon l'une des revendications 1 à 10, comprenant en outre :
des zones de commutation (109) supplémentaires de telle sorte que la couche semi-conductrice (104) comporte plusieurs zones de commutation (190), dans laquelle chaque zone de commutation (190) a une première partie (191) et une seconde partie (192) adjacente à la première partie (191) ; et
des commutateurs supplémentaires (100.1, 100.2) de telle sorte que la structure comprenne plusieurs commutateurs (100, 100.1, 100.2),
dans laquelle chaque commutateur (100, 100.1, 100.2) comprend :
une zone de commutation associée (190) parmi les multiples zones de commutation (190) ; et
des transistors connectés en série (110, 120, 130) comportant :
à l'intérieur de la première partie (191) de la zone de commutation associée (190), des régions de source/drain (111, 112, 121, 122, 131, 132) et des régions de canal (113, 123, 133) positionnées latéralement entre les régions de source/drain (111, 112, 121, 122, 131, 132) ; et
des grilles (115, 125, 135) adjacentes aux régions de canal (113, 123, 133), respectivement, dans laquelle les grilles (115, 125, 135) traversent la première partie (191) de la zone de commutation associée (190) et dans laquelle la seconde partie (192) de la zone de commutation associée (190) s'étend au-delà des grilles (115, 125, 135),
dans laquelle chaque commutateur (100, 100.1, 100.2) comprend de préférence en outre des éléments résistifs (119, 129, 139) dans la seconde partie (192) de la zone de commutation (190) connectés en parallèle aux transistors connectés en série (110, 120, 130) et/ou les commutateurs (100) sont de préférence connectés en série.

12. Structure selon l'une des revendications 1 à 10, dans laquelle la zone de commutation (190) comporte une première extrémité, une seconde extrémité opposée à la première extrémité, la première partie (191) s'étendant de la première extrémité à la seconde extrémité, et la seconde partie (192) étant adjacente à la première partie et s'étendant de la première extrémité à la seconde extrémité ; et
dans laquelle la structure comprend en outre des commutateurs supplémentaires (100.1, 100.2) de telle sorte que la structure comprenne plusieurs commutateurs (100, 100.1, 100.2),
dans laquelle chaque commutateur (100, 100.1, 100.2) comporte :
des transistors connectés en série (110, 120, 130) comportant :
dans la première partie (191) de la zone de commutation (190), des régions de source/drain (111, 112, 121, 122, 131, 132) et des régions de canal (113, 123, 133) positionnées latéralement entre les régions de source/drain (111, 112, 121, 122, 131, 132) ; et
des grilles (115, 125, 135) adjacentes aux régions de canal (113, 123, 133), respectivement, dans laquelle les grilles (115, 125, 135) traversent la première partie (191) de la zone de commutation (190) et dans laquelle la seconde partie (192) de la zone de commutation (190) s'étend au-delà des grilles (115, 125, 135) ; et
des éléments résistifs (119, 129, 139) dans la seconde partie (192) de la zone de commutation (190) connectés en parallèle aux transistors connectés en série (110, 120, 130),
dans laquelle les multiples commutateurs (100, 100.1, 100.2) comportent un premier commutateur et un second commutateur connectés en parallèle, et
dans laquelle les régions de source/drain (111, 112, 121, 122, 131, 132) des transistors connectés en série (110, 120, 130) du premier commutateur et les régions de source/drain (111, 112, 121, 122, 131, 132) des transistors connectés en série (110, 120, 130) du second commutateur comportent une région de source/drain interne commune (112, 131, 132, 121) centrée au sein de la première partie (191) de la zone de commutation (190).

13. Structure selon la revendication 11 ou 12,
dans laquelle les régions de source/drain (111, 112, 121, 122, 131, 132) des transistors connectés en série (110, 120, 130) du premier commutateur et des transistors connectés en série (110, 120, 130) du second commutateur comportent des régions de source/drain externes discrètes (11, 122) respectivement situées au niveau de la première extrémité et au niveau de la seconde extrémité, et
dans laquelle la structure comporte en outre des couches de siliciure (185) au-dessus de la région de source/drain commune (112, 131, 132, 121), de la première région de source/drain externe (111) et de la deuxième région de source/drain externe (122), et
dans laquelle toutes les autres régions de source/drain (112, 131, 132, 121) de la structure ne sont pas recouvertes de siliciure.

14. Structure selon l'une des revendications 11 à 13,
dans laquelle les grilles (115, 125, 135) ont des sections principales positionnées latéralement entre les régions de source/drain surélevées (111*r*-112*r*, 131*r-*132*r,* 121*r-*122*r*) et des sections d'extrémité s'étendant respectivement depuis les sections principales, au-delà des régions de source/drain surélevées (111*r*-112*r*, 131*r*-132*r*, 121*r-*122*r*) vers la seconde partie (192),
dans laquelle les sections d'extrémité comportent une première couche conductrice de grille en polysilicium (117, 127, 137) et les sections principales comportent la première couche conductrice de grille en polysilicium (117, 127, 137) et une seconde couche conductrice de grille en polysilicium (118, 128, 138) sur la première couche conductrice de grille en polysilicium (117, 127, 137),
dans laquelle les sections d'extrémité ont une première hauteur (h1) et les sections principales ont une seconde hauteur (h2) qui est supérieure à la première hauteur (h1), et
dans laquelle les commutateurs (100, 100.1, 100.2) comportent en outre :
une première couche diélectrique (161) située au-dessus et immédiatement adjacente à la seconde partie (192), s'étendant sur une zone de transition de la première partie (191) immédiatement adjacente à la seconde partie (192), et s'étendant en outre sur la première couche conductrice de grille en polysilicium (117, 127, 137) des sections d'extrémité des grilles (115, 125, 135) ; et
une seconde couche diélectrique (162) au-dessus de toute région de source/drain (111, 112, 131, 132, 121, 122) entre la région de drain commune (112, 131, 132, 121) et la première région de source externe (111) ou entre la région de drain commune (112, 131, 132, 121) et la seconde région de source externe (122), et en outre au-dessus et immédiatement adjacente à la seconde couche conductrice de grille en polysilicium (118, 128, 138) des sections principales des grilles (115, 125, 135).
